# EUROPEAN PATENT APPLICATION

(11) **EP 4 560 704 A1**
(43) Date of publication of application: **28.05.2025**
(21) Application number: 22946037.3
(22) Date of filing: 21.10.2022
(51) Int. Cl.: H01L 25/065, H01L 23/48

(54) **SEMICONDUCTOR CHIP, SEMICONDUCTOR DEVICE AND FORMING METHOD THEREFOR**

(30) Priority: 07.09.2022 CN 202211090956
(71) Applicant: Changxin Memory Technologies, Inc., Hefei, Anhui 230601 (CN)
(72) Inventor: ZHANG, Jiarui, Hefei City, Anhui Province 230601 (CN)
(74) Representative: Lavoix
(86) International application number: PCT/CN2022/126585
(87) International publication number: WO 2024/050930

(57) **Abstract**

The application relates to a semiconductor die, a semiconductor device and a method for forming a semiconductor device. The semiconductor die includes: a substrate including a top surface and a bottom surface; and a plurality of pairs of signal via groups independent of each other, a plurality of signal via groups being arranged in the substrate and spaced apart from each other, two signal via groups in each pair of signal via groups are distributed symmetrically with respect to an axis located on the top surface of the substrate, one of the two signal via groups being distributed in a first region arranged on one side of the axis, and another one of the two signal via groups being distributed in a second region arranged on another side of the axis, the axis being parallel to a first direction or a second direction, each signal via group including a plurality of signal vias arranged in a polygonal shape, any two signal vias in each signal via group being electrically isolated from each other, and each signal via penetrating through the substrate along a third direction.

## Description

### CROSS-REFERENCE TO RELATED APPLICATION

This application claims priority to Chinese Patent application No. 202211090956.6, filed on September 7, 2022 and entitled "SEMICONDUCTOR DIE, SEMICONDUCTOR DEVICE AND METHOD FOR FORMING SEMICONDUCTOR DEVICE", the contents of which are incorporated herein by reference in its entirety.

### TECHNICAL FIELD

The application relates to the technical field of semiconductor manufacturing, and in particular to a semiconductor die, a semiconductor device and a method for forming a semiconductor device.

### BACKGROUND

With the development of integrated circuit technology, the production processes of semiconductor devices have made great progress. However, in recent years, the development of two-dimensional semiconductor technology has encountered various challenges: physical limits, existing development technology limits, stored electron density limits, or the like. In this context, in order to solve difficulties encountered by two-dimensional semiconductor devices and pursue lower production cost per memory cell, semiconductor devices with three-dimensional structures emerge.

At present, multiple dies may be stacked through a bonding process to form a semiconductor device with a three-dimensional stack die structure. However, an existing process of implementing stacking of multiple dies is relatively complex. For example, it needs to use multiple sets of masks or to provide multiple contacts inside the die, which results in increase of manufacturing cost and manufacturing difficulty of the semiconductor device, and is not conducive to improvement of yield of the semiconductor device.

Therefore, at present, how to simplify the manufacturing process of forming a semiconductor device with a multi-die stack structure, reduce the manufacturing cost of the semiconductor device while improving the yield of the semiconductor device is an urgent technical problem to be solved.

### SUMMARY

Some embodiments of the application provide a semiconductor die, a semiconductor device and a method for forming a semiconductor device, which simplify the manufacturing process of a semiconductor device with a multi-die stack structure, reduce the manufacturing cost of the semiconductor device, while improving the yield of the semiconductor device.

Based on this, according to an aspect, the application provides a semiconductor die, which includes a substrate and a plurality of pairs of signal via groups which are independent of each other.

The substrate includes a top surface and a bottom surface arranged opposite to the top surface.

A plurality of signal via groups are arranged in the substrate and spaced apart from each other. Two signal via groups in each pair of the plurality of pairs of signal via groups are distributed symmetrically with respect to an axis located on the top surface of the substrate. One of the two signal via groups is distributed in a first region arranged on one side of the axis, and another one of the two signal via groups is distributed in a second region arranged on another side of the axis. The axis is parallel to a first direction or a second direction. Each of the plurality of signal via groups includes a plurality of signal vias arranged in a polygonal shape. Any two of the plurality of signal vias in each of the plurality of signal via groups are electrically isolated from each other. Each of the plurality of signal vias penetrates through the substrate along a third direction. The first direction and the second direction are perpendicular to each other and are parallel to the top surface of the substrate, and the third direction is a direction perpendicular to the top surface of the substrate.

In some embodiments, the semiconductor die further includes a plurality of top metal interconnection structures.

The plurality of top metal interconnection structures are located on the top surface of the substrate. Each of the plurality of top metal interconnection structures corresponds to and is electrically connected to a respective one of the plurality of signal via groups. Each of the plurality of top metal interconnection structures includes a plurality of conductive paths. Each of the plurality of conductive paths corresponds to and is electrically connected to a respective one of the plurality of signal vias in the respective one of the plurality of signal via groups.

In some embodiments, each of the plurality of top metal interconnection structures includes a first conductive layer, a second conductive layer, and a plurality of connection elements.

The first conductive layer is located on the top surface of the substrate and includes a plurality of first conductive elements spaced apart from each other. The plurality of first conductive elements are arranged in the polygonal shape. Each of the plurality of first conductive elements corresponds to and is electrically connected to a respective one of the plurality of signal vias in the respective one of the plurality of signal via groups.

The second conductive layer is located on the first conductive layer and includes a plurality of second conductive elements spaced apart from each other. Each of the plurality of second conductive elements corresponds to a respective one of the plurality of first conductive elements. The plurality of second conductive elements are arranged in the polygonal shape, and a portion of each of the plurality of second conductive elements is overlapped with a portion of the respective one of the plurality of first conductive elements.

Each of the plurality of connection elements corresponds to a respective one of the plurality of first conductive elements and a respective one of the plurality of second conductive elements, and each of the plurality of connection elements is configured to electrically connect the respective one of the plurality of first conductive elements with the respective one of the plurality of second conductive elements, to form a respective one of the plurality of conductive paths.

In some embodiments, each of the plurality of first conductive elements includes a first end and a second end, the first end being arranged opposite to the second end along an extension direction of said each of the plurality of first conductive elements. Each of the plurality of second conductive elements includes a third end and a fourth end, the third end being arranged opposite to the fourth end along an extension direction of said each of the plurality of second conductive elements.

The first end of each of the plurality of first conductive elements corresponds to and is electrically connected to the respective one of the plurality of signal vias.

For each of the plurality of second conductive elements and the respective one of the plurality of first conductive elements, an end of a respective one of the plurality of connection elements is electrically connected to the third end of said each of the plurality of second conductive elements, and another end of the respective one of the plurality of connection elements is electrically connected to the second end of the respective one of the plurality of first conductive elements.

In some embodiments, the semiconductor die further includes a plurality of internal circuits.

Each of the plurality of internal circuits corresponds to a respective one of the plurality of top metal interconnection structures, and each of the plurality of internal circuits is electrically connected to a respective one of the plurality of conductive paths in the respective one of the plurality of top metal interconnection structures.

In some embodiments, the semiconductor die further includes a plurality of lead-out wires.

Each of the plurality of lead-out wires corresponds to a respective one of the plurality of internal circuits. An end of each of the plurality of lead-out wires is electrically connected to the respective one of the plurality of internal circuits, and another end of each of the plurality of lead-out wires is only electrically connected to a respective one of the plurality of first conductive elements in the respective one of the plurality of top metal interconnection structures.

In some embodiments, each of the plurality of signal via groups includes four signal vias. The four signal vias are arranged in a square shape or a diamond shape.

According to another aspect, the application further provides a semiconductor device, which includes a base plate and a stack structure.

The stack structure is located on the base plate and includes N cell structures. The N cell structures are sequentially stacked on one another in the third direction and are electrically connected to each other. Each of the N cell structures includes four semiconductor dies according to claim 1. N is a positive integer.

The four semiconductor dies in each of the N cell structures are sequentially stacked on one another along the third direction. A first semiconductor die at a bottommost layer of the four semiconductor dies is stacked face-to-face with a second semiconductor die arranged above the first semiconductor die, the second semiconductor die is stacked back-to-back with a third semiconductor die arranged above the second semiconductor die, and the third semiconductor die is stacked face-to-face with a fourth semiconductor die arranged above the third semiconductor die.

Axes of any two adjacent semiconductor dies of a plurality of semiconductor dies in the stack structure are aligned with each other, and the first region of one of the any two adjacent semiconductor dies is aligned with the second region of another one of the any two adjacent semiconductor dies.

Face-to-face means that top surfaces of two adjacent semiconductor dies face towards each other, and back-to-back means that bottom surfaces of two adjacent semiconductor dies face towards each other.

In some embodiments, the semiconductor device further includes a plurality of pairs of signal transmission link groups.

Each pair of the plurality of pairs of signal transmission link groups corresponds to a respective one of the plurality of pairs of signal via groups in each of the plurality of semiconductor dies. Each of a plurality of signal transmission link groups includes a plurality of signal transmission links. The plurality of signal transmission links in each of the plurality of signal transmission link groups are independent of each other and each spirally extend along the third direction. Each of the plurality of signal transmission links in each of the plurality of signal transmission link groups corresponds to a respective one of the plurality of signal vias in a respective one of the plurality of signal via groups in each of the plurality of semiconductor dies, and each of the plurality of signal transmission links includes the respective one of the plurality of signal vias in each of the plurality of semiconductor dies.

In some embodiments, the semiconductor device further includes a plurality of pairs of bonding pillar groups.

The plurality of pairs of bonding pillar groups are located only between any two adjacent semiconductor dies stacked face-to-face with each other. Each pair of the plurality of pairs of bonding pillar groups corresponds to a respective one of the plurality of pairs of signal via groups in each of the any two adjacent semiconductor dies stacked face-to-face with each other, to implement signal transmission between the any two adjacent semiconductor dies stacked face-to-face with each other. Each of a plurality of bonding pillar groups includes a plurality of bonding pillars. Each of the plurality of bonding pillars corresponds to a respective one of the plurality of signal vias in each of the any two adjacent semiconductor dies stacked face-to-face with each other. Each pair of the plurality of pairs of signal transmission link groups corresponds to a respective one of the plurality of pairs of bonding pillar groups located between the any two adjacent semiconductor dies stacked face-to-face with each other. Each of the plurality of signal transmission links in each of the plurality of signal transmission link groups corresponds to a respective one of the plurality of bonding pillars in the respective one of the plurality of pairs of bonding pillar groups, and each of the plurality of signal transmission links includes the respective one of the plurality of bonding pillars arranged between the any two adjacent semiconductor dies stacked face-to-face with each other.

In some embodiments, for any two adjacent semiconductor dies stacked back-to-back with each other, each of the plurality of signal vias in one of the any two adjacent semiconductor dies stacked back-to-back with each other corresponds to and is electrically connected with a respective one of the plurality of signal vias in another one of the any two adjacent semiconductor dies stacked back-to-back with each other.

In some embodiments, each of the plurality of semiconductor dies includes a plurality of top metal interconnection structures. The plurality of top metal interconnection structures are located on the top surface of the substrate. Each of the plurality of top metal interconnection structures corresponds to and is electrically connected to a respective one of the plurality of signal via groups. Each of the plurality of top metal interconnection structures includes a plurality of conductive paths, each of the plurality of conductive paths corresponding to and being electrically connected to a respective one of the plurality of signal vias in the respective one of the plurality of signal via groups, and each of the plurality of signal transmission links includes a respective one of the plurality of signal vias and a respective one of the plurality of conductive paths in each of the plurality of semiconductor dies.

Each of the plurality of top metal interconnection structures includes a first conductive layer, a second conductive layer, and a plurality of connection elements. The first conductive layer is located on the top surface of the substrate and includes a plurality of first conductive elements spaced apart from each other. The plurality of first conductive elements are arranged in the polygonal shape, and each of the plurality of first conductive elements corresponds to and is electrically connected to a respective one of the plurality of signal vias in the respective one of the plurality of signal via groups. The second conductive layer is located on the first conductive layer and includes a plurality of second conductive elements spaced apart from each other. Each of the plurality of second conductive elements corresponds to a respective one of the plurality of first conductive elements. The plurality of second conductive elements are arranged in the polygonal shape, and a portion of each of the plurality of second conductive elements is overlapped with a portion of the respective one of the plurality of first conductive elements. Each of the plurality of connection elements corresponds to a respective one of the plurality of first conductive elements and a respective one of the plurality of second conductive elements, and each of the plurality of connection elements is configured to electrically connect the respective one of the plurality of first conductive elements with the respective one of the plurality of second conductive elements, to form a respective one of the plurality of conductive paths.

Each of the plurality of first conductive elements includes a first end and a second end, the first end being arranged opposite to the second end along an extension direction said each of the plurality of first conductive elements. Each of the plurality of second conductive elements includes a third end and a fourth end, the third end being arranged opposite to the fourth end along an extension direction of said each of the plurality of second conductive elements. The first end of each of the plurality of first conductive elements corresponds to and is electrically connected to the respective one of the plurality of signal vias. For each of the plurality of second conductive elements and the respective one of the plurality of first conductive elements, an end of a respective one of the plurality of connection elements is electrically connected to the third end of said each of the plurality of second conductive elements, and another end of the respective one of the plurality of connection element is electrically connected to the second end of the respective one of the plurality of first conductive elements.

In some embodiments, for the any two adjacent semiconductor dies stacked face-to-face with each other, each pair of the plurality of pairs of bonding pillar groups corresponds to a respective one of the plurality of top metal interconnection structures of each of the any two adjacent semiconductor dies stacked face-to-face with each other. An end of each of the plurality of bonding pillars is electrically connected to the fourth end of a respective one of the plurality of second conductive elements in one of the any two adjacent semiconductor dies stacked face-to-face with each other, and another end of each of the plurality of bonding pillars is electrically connected to the fourth end of a respective one of the plurality of second conductive elements in another one of the any two adjacent semiconductor dies stacked face-to-face with each other.

In some embodiments, each of the plurality of semiconductor dies further includes a plurality of internal circuits and a plurality of lead-out wires.

Each of the plurality of internal circuits corresponds to a respective one of the plurality of top metal interconnection structures, and each of the plurality of internal circuits is electrically connected to a respective one of the plurality of conductive paths in the respective one of the plurality of top metal interconnection structures.

Each of the plurality of lead-out wires corresponds to a respective one of the plurality of internal circuits. An end of each of the plurality of lead-out wires is electrically connected to the respective one of the plurality of internal circuits, and another end of each of the plurality of lead-out wires is only electrically connected to a respective one of the plurality of first conductive elements in the respective one of the plurality of top metal interconnection structures.

In some embodiments, for each of the N cell structures, one of the plurality of signal transmission links is only electrically connected to one of the plurality of lead-out wires in one of the plurality of semiconductor dies.

In some embodiments, the semiconductor device further includes an interface circuit.

The interface circuit is located in the base plate and is electrically connected to the plurality of pairs of signal transmission link groups. The interface circuit is configured to transmit a plurality of control signals to the plurality of signal transmission link groups, each of the plurality of control signals corresponding to a respective one of the plurality of signal transmission links in the plurality of signal transmission link groups, and each of the plurality of control signals being only led out from one of the plurality of lead-out wires in one of the plurality of semiconductor dies in each of the N cell structures.

For each pair of the plurality of pairs of signal via groups in one of the plurality of semiconductor dies, the interface circuit outputs a first control signal to a lead-out wire electrically connected to one of the plurality of signal vias in one of the plurality of signal via groups through a respective one of the plurality of signal transmission links, and transmits a second control signal, which is different from the first control signal, to a lead-out wire electrically connected to one of the plurality of signal vias in another one of plurality of signal via groups through another respective one of the plurality of signal transmission links.

According to yet another aspect, the application further provides a method for forming a semiconductor device, which includes the following operations.

A base plate is provided.

A plurality of semiconductor dies are formed, in which each of the plurality of semiconductor dies includes a substrate, and a plurality of pairs of signal via groups which are independent of each other, in which the substrate includes a top surface and a bottom surface arranged opposite to the top surface, a plurality of signal via groups are arranged in the substrate and spaced apart from each other, two signal via groups in each pair of the plurality of pairs of signal via groups are distributed symmetrically with respect to an axis located on the top surface of the substrate, one of the two signal via groups is distributed in a first region arranged on one side of the axis, and another one of the two signal via groups is distributed in a second region arranged on another side of the axis, the axis being parallel to a first direction or a second direction, each of the plurality of signal via groups includes a plurality of signal vias arranged in a polygonal shape, any two of the plurality of signal vias in each of the plurality of signal via groups are electrically isolated from each other, each of the plurality of signal vias penetrates through the substrate along a third direction, in which the first direction and the second direction are perpendicular to each other and are parallel to the top surface of the substrate, and the third direction is a direction perpendicular to the top surface of the substrate.

A stack structure is formed on the base plate based on the plurality of semiconductor dies, in which the stack structure includes N cell structures, the N cell structures are sequentially stacked on one another in the third direction and are electrically connected to each other, each of the N cell structures includes four semiconductor dies, the four semiconductor dies in each of the N cell structures are sequentially stacked on one another along the third direction, a first semiconductor die at a bottommost layer of the four semiconductor dies is stacked face-to-face with a second semiconductor die arranged above the first semiconductor die, the second semiconductor die is stacked back-to-back with a third semiconductor die arranged above the second semiconductor die, and the third semiconductor die is stacked face-to-face with a fourth semiconductor die arranged above the third semiconductor die, in which N is a positive integer.

Axes of any two adjacent semiconductor dies of the plurality of semiconductor dies in the stack structure are aligned with each other, and the first region of one of the any two adjacent semiconductor dies is aligned with the second region of another one of the any two adjacent semiconductor dies.

Face-to-face means that top surfaces of two adjacent semiconductor dies face towards each other, and back-to-back means that bottom surfaces of two adjacent semiconductor dies face towards each other.

In some embodiments, the operation that the plurality of semiconductor dies are formed includes the following specific operations.

The substrate is formed, and the first region arranged on said one side of the axis and the second region arranged on the other side of the axis are defined in the substrate.

The plurality of signal via groups penetrating through the substrate along the third direction are formed in each of the first region and the second region.

A plurality of top metal interconnection structures are formed on the top surface of the substrate, in which each of the plurality of top metal interconnection structures corresponds to and is electrically connected to a respective one of the plurality of signal via groups, each of the plurality of top metal interconnection structures includes a plurality of conductive paths, each of the plurality of conductive paths corresponds to and is electrically connected to a respective one of the plurality of signal vias in the respective one of the plurality of signal via groups.

In some embodiments, the operation that the plurality of top metal interconnection structures are formed on the top surface of the substrate includes the following specific operations.

A first conductive layer is formed on the top surface of the substrate, in which the first conductive layer includes a plurality of first conductive elements spaced apart from each other, the plurality of first conductive elements are arranged in the polygonal shape, each of the plurality of first conductive elements includes a first end and a second end, the first end is arranged opposite to the second end along an extension direction of said each of the plurality of first conductive elements, and first end of each of the plurality of first conductive elements corresponds to and is electrically connected to a respective one of the plurality of signal vias in a respective one of the plurality of signal via groups.

A second conductive layer is formed above the first conductive layer, in which the second conductive layer includes a plurality of second conductive elements spaced apart from each other, each of the plurality of second conductive elements corresponds to a respective one of the plurality of first conductive elements, the plurality of second conductive elements are arranged in the polygonal shape, each of the plurality of second conductive elements includes a third end and a fourth end, the third end being arranged opposite to the fourth end along an extension direction of said each of the plurality of second conductive elements, and a portion of each of the plurality of second conductive elements is overlapped with a portion of the respective one of the plurality of first conductive elements.

A plurality of connection elements are formed between the first conductive layer and the second conductive layer, in which for each of the plurality of second conductive elements and the respective one of the plurality of first conductive elements, an end of a respective one of the plurality of connection elements is electrically connected to the third end of said each of the plurality of second conductive elements, and another end of the respective one of the plurality of connection elements is electrically connected to the second end of the respective one of the plurality of first conductive elements, to form a respective one of the plurality of conductive paths.

In some embodiments, the operation that the stack structure is formed on the base plate based on the plurality of semiconductor dies includes the following specific operations.

The four semiconductor dies are provided.

The first semiconductor die is placed on the base plate.

The second semiconductor die is stacked above the first semiconductor die in a manner that the second semiconductor die is arranged face-to-face with the first semiconductor die.

The third semiconductor die is stacked above the second semiconductor die in a manner that the third semiconductor die is arranged back-to-back with the second semiconductor die.

The fourth semiconductor die is stacked above the third semiconductor die in a manner that the fourth semiconductor die is arranged face-to-face with the third semiconductor die, to form a cell structure including the first semiconductor die, the second semiconductor die, the third semiconductor die and the fourth semiconductor die.

Above operations are repeated on the formed cell structure, to sequentially form the N cell structures stacked on one another along the third direction.

The axes of the any two adjacent semiconductor dies in the stack structure are aligned with each other, and the first region of said one of the any two adjacent semiconductor dies is aligned with the second region of the other one of the any two adjacent semiconductor dies.

In some embodiments, the operation that the second semiconductor die is stacked above the first semiconductor die in the manner that the second semiconductor die is arranged face-to-face with the first semiconductor die includes the following specific operations.

One of a plurality of bonding pillar groups is formed on each of the plurality of top metal interconnection structures of the first semiconductor die, in which each of the plurality of bonding pillar groups includes a plurality of bonding pillars, a bottom end of each of the plurality of bonding pillars is bonded and connected to the fourth end of a respective one of the plurality of second conductive elements in the first semiconductor die.

A top end of each of the plurality of bonding pillars is bonded and connected to a respective one of the plurality of top metal interconnection structures of the second semiconductor die, and the top end of each of the plurality of bonding pillars is bonded and connected to the fourth end of a respective one of the plurality of second conductive elements in the second semiconductor die.

In some embodiments, the operation that the third semiconductor die is stacked above the second semiconductor die in the manner that the third semiconductor die is arranged back-to-back with the second semiconductor die includes the following specific operations.

Each of the plurality of signal vias arranged in the second semiconductor die contacts or is electrically connected with a respective one of the plurality of signal vias arranged in the third semiconductor die.

In some embodiments, each of the plurality of semiconductor dies further includes a plurality of internal circuits, each of the plurality of internal circuits corresponding to a respective one of the plurality of top metal interconnection structures. The method for forming the semiconductor device further includes the following operations.

A lead-out wire is formed between each of the plurality of internal circuits and the respective one of the plurality of top metal interconnection structures, to allow each of the plurality of internal circuits to be electrically connected to a respective one of the plurality of conductive paths in the respective one of the plurality of top metal interconnection structures.

In some embodiments, the method for forming the semiconductor device further includes the following operations.

An interface circuit is formed in the base plate.

The any two adjacent semiconductor dies in the stack structure are electrically connected with each other, to form a plurality of pairs of signal transmission link groups, each pair of the plurality of pairs of signal transmission link groups corresponding to a respective one of the plurality of pairs of signal via groups in each of the any two adjacent semiconductor dies, in which each of a plurality of signal transmission link groups includes a plurality of signal transmission links, each of the plurality of signal transmission links includes a respective one of the plurality of signal vias in each of the any two adjacent semiconductor dies, a respective one of the plurality of conductive paths in each of the any two adjacent semiconductor dies, and a respective one of the plurality of bonding pillars arranged between the any two adjacent semiconductor dies stacked face-to-face with each other.

The interface circuit is electrically connected to the plurality of pairs of signal via groups in a semiconductor die at a bottommost layer of the stack structure, and the interface circuit is electrically connected to the plurality of pairs of signal transmission link groups, to transmit a plurality of control signals to the plurality of signal transmission link groups, each of the plurality of control signals corresponding to a respective one of the plurality of signal transmission links in the plurality of signal transmission link groups, and each of the plurality of control signals being only led out to a respective one of the plurality of internal circuits through one lead-out wire in one of the plurality of semiconductor dies in each of the N cell structures; and in which for each pair of the plurality of pairs of signal via groups in one of the plurality of semiconductor dies, the interface circuit is further configured to output a first control signal to a lead-out wire electrically connected to one of the plurality of signal vias in one of the plurality of signal via groups through a respective one of the plurality of signal transmission links, and transmit a second control signal, which is different from the first control signal, to a lead-out wire electrically connected to one of the plurality of signal vias in another one of the plurality of signal via groups through another respective one of the plurality of signal transmission links.

According to the semiconductor die, the semiconductor device and the method for forming the semiconductor device provided by some embodiments of the application, the plurality of pairs of signal via groups which are independent of each other are provided in the semiconductor die, the plurality of signal via groups are arranged in the substrate and spaced apart from each other, two signal via groups in each pair of signal via groups are distributed symmetrically with respect to an axis located on the top surface of the substrate, one of the two signal via groups is distributed in the first region arranged on one side of the axis, and another one of the two signal via groups is distributed in the second region arranged on another side of the axis, so that when the plurality of semiconductor dies are stacked on one another, face-to-face stacking and connection of the semiconductor dies may be achieved by just performing simple rotation operations, thereby ensuring that the same control signal in the semiconductor device propagates upward in one direction, reducing the number of masks required in a process of forming the semiconductor device, simplifying the operation of sequentially stacking the plurality of semiconductor dies, reducing the manufacturing difficulty of the semiconductor device, and contributing to improving the yield of the semiconductor device.

### BRIEF DESCRIPTION OF THE DRAWINGS

FIG. 1 is a schematic top view of a semiconductor die according to a specific implementation of the application;
FIG. 2 is a steric schematic diagram of a first region of a semiconductor die according to a specific implementation of the application;
FIG. 3 is a steric schematic diagram of a second region of a semiconductor die according to a specific implementation of the application;
FIG. 4A to FIG. 4C are schematic diagrams of a stack structure of a semiconductor device according to a specific implementation of the application;
FIG. 5 is a schematic diagram of a structure after bonding a first region of a first semiconductor die to a second region of a second semiconductor die according to a specific implementation of the application;
FIG. 6 is a schematic diagram of a structure after bonding a second region of a first semiconductor die to a first region of a second semiconductor die according to a specific implementation of the application;
FIG. 7 is a schematic cross-sectional view of a semiconductor device according to a specific implementation of the application; and
FIG. 8 is a flowchart of a method for forming a semiconductor device according to a specific implementation of the application.

### DETAILED DESCRIPTION

Specific implementations of a semiconductor device and a method for forming a semiconductor device provided in the application will be described in detail below with reference to the accompanying drawings.

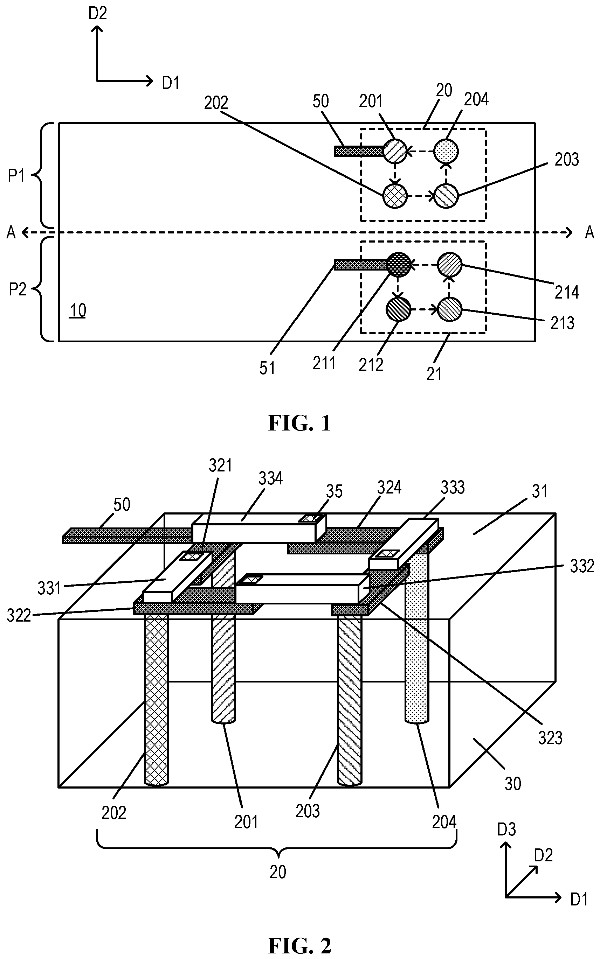

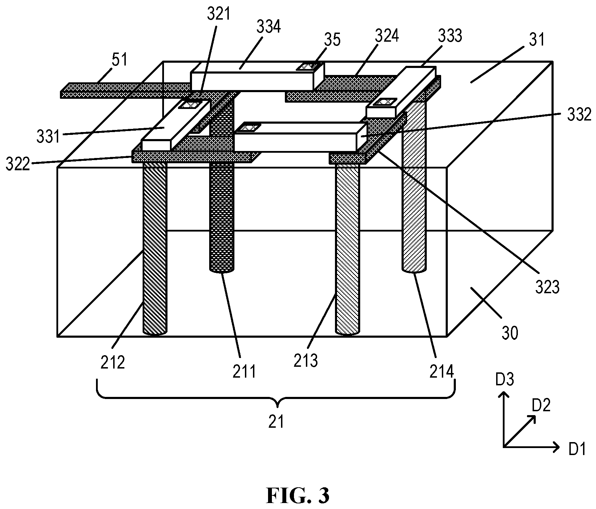

This specific implementation provides a method for forming a semiconductor device. FIG. 1 is a schematic top view of a semiconductor die according to a specific implementation of the application, FIG. 2 is a steric schematic diagram of a first region of a semiconductor die according to a specific implementation of the application, and FIG. 3 is a steric schematic diagram of a second region of a semiconductor die according to a specific implementation of the application. As shown in FIG. 1 to FIG. 3, the semiconductor die includes a substrate 10, and a plurality of pairs of signal via groups which are independent of each other.

The substrate 10 includes a top surface 31 and a bottom surface 30 arranged opposite to the top surface 31.

A plurality of signal via groups are arranged in the substrate 10 and spaced apart from each other. Two signal via groups in each pair of the plurality of pairs of signal via groups are distributed symmetrically with respect to an axis AA located on the top surface 31 of the substrate 10. One of the two signal via groups is distributed in a first region P1 arranged on one side of the axis AA, and another one of the two signal via groups is distributed in a second region P2 on another side of the axis AA. The axis AA is parallel to a first direction D1 or a second direction D2. Each of the plurality of signal via groups includes a plurality of signal vias arranged in a polygonal shape. Any two of the plurality of signal vias in each of the plurality of signal via groups are electrically isolated from each other, each of the plurality of signal vias penetrates through the substrate along a third direction D3. The first direction D1 and the second direction D2 are perpendicular to each other and are parallel to the top surface 31, and the third direction D3 is a direction perpendicular to the top surface 31 of the substrate 10.

Specifically, the semiconductor die is a Dynamic Random Access Memory, DRAM, die. Multiple pairs in this specific implementation may be two or more pairs. Hereinafter, descriptions will be made by an example of a pair of signal via groups in the semiconductor die and each of the signal via groups including four signal vias. As shown in FIG. 1, the semiconductor die includes the first region P1 and the second region P2 distributed symmetrically with respect to the axis AA, and a pair of signal via groups include a first signal via group 20 located in the first region P1 and a second signal via group 21 located in the second region P2, and the first signal via group 20 and the second signal via group 21 are distributed symmetrically with respect to the axis AA. Each of the first signal via group 20 and the second signal via group 21 includes a plurality of signal vias arranged in the polygonal shape, and the plurality of signal vias are configured to transmit multiple different control signals respectively. Such distribution of the signal via groups may ensure that when the semiconductor dies are stacked (for example, stacked face-to-face) on one another, it is unnecessary to change the manufacturing processes of a single semiconductor die, thereby simplifying the process flows. In an example, specific numbers, structures and materials of multiple signal vias in the first signal via group 20 are the same as specific numbers, structures and materials of multiple signal vias in the second signal via group 21, which may not only simplify the manufacturing process of the semiconductor die, but also facilitate transmitting different types of control signals through multiple signal vias respectively, thereby reducing the driving load of the semiconductor die. The above descriptions are exemplified only. In other specific implementations, the semiconductor die may further include two or more pairs of signal via groups, and two signal via groups in each pair of signal via groups are distributed symmetrically with respect to the axis AA, and multiple signal via groups located on the same side of the axis AA are spaced apart from each other.

For example, with reference to FIG. 1, the first signal via group 20 includes a first signal via 201, a second signal via 202, a third signal via 203 and a fourth signal via 204 which are sequentially arranged in a counterclockwise direction, and the second signal via group 21 includes a fifth signal via 211, a sixth signal via 212, a seventh signal via 213 and an eighth signal via 214 which are sequentially arranged in a clockwise direction.

With reference to FIG. 2 and FIG. 3, in some embodiments, the semiconductor die further includes a plurality of top metal interconnection structures.

The plurality of top metal interconnection structures are located on the top surface 31 of the substrate 10, and each of the plurality of top metal interconnection structures corresponds to and is electrically connected to a respective one of the plurality of signal via groups. Each of the plurality of top metal interconnection structures includes a plurality of conductive paths, each of the plurality of conductive paths corresponds to and is electrically connected to a respective one of the plurality of signal vias in the respective one of the plurality of signal via groups.

Specifically, the plurality of conductive paths which are independent of each other are arranged in the top metal interconnection structure of the semiconductor die, so that multiple control signals may be transmitted along the plurality of conductive paths respectively, which may reduce crosstalk between different control signals while ensuring stable transmission of each control signal inside the semiconductor die, and may also ensure implementation of a spiraling signal transmission path when the semiconductor dies are stacked on one another, thereby improving the electrical performance of the semiconductor dies.

With reference to FIG. 2 and FIG. 3, in some embodiments, each of the plurality of top metal interconnection structures includes a first conductive layer, a second conductive layer, and a plurality of connection elements 35.

The first conductive layer is located on the top surface of the substrate 10, and includes a plurality of first conductive elements spaced apart from each other. The plurality of first conductive elements are arranged in the polygonal shape, and each of the plurality of first conductive elements corresponds to and is electrically connected to a respective one of the plurality of signal vias in the respective one of the plurality of signal via groups.

The second conductive layer is located on the first conductive layer, and includes a plurality of second conductive elements spaced apart from each other. Each of the plurality of second conductive elements corresponds to a respective one of the plurality of first conductive elements. The plurality of second conductive elements are arranged in the polygonal shape, and a portion of each of the plurality of second conductive elements is overlapped with a portion of the respective one of the plurality of first conductive elements.

Each of the plurality of connection elements 35 correspond to a respective one of the plurality of second conductive elements, and each of the plurality of connection elements is configured to electrically connect the respective one of the plurality of second conductive elements with a respective one of the plurality of first conductive elements.

Specifically, the top metal interconnection structure includes the first conductive layer and the second conductive layer arranged in layers along the third direction D3. The number of the first conductive elements in the first conductive layer, the number of the second conductive elements in the second conductive layer, and the number of the connection elements 35 are the same. Hereinafter, descriptions will be made by an example of the semiconductor die including a first top metal interconnection structure on the first signal via group 20 and a second top metal interconnection structure on the second signal via group 21. As shown in FIG. 2, the first conductive layer in the first top metal interconnection structure includes four first conductive elements (i.e., a left-side first conductive element 321 electrically connected to a first signal via 201, a front-side first conductive element 322 electrically connected to a second signal via 202, a right-side first conductive element 323 electrically connected to a third signal via 203, and a rear-side first conductive element 324 electrically connected to a fourth signal via) corresponding to and electrically connected to four signal vias (i.e., the first signal via 201, the second signal via 202, the third signal via 203, and the fourth signal via 204) in the first signal via group 20, respectively. The second conductive layer includes a plurality of second conductive elements (i.e., a left-side second conductive element 331 electrically connected to the left-side first conductive element 321 through the connection element 35, a front-side second conductive element 332 electrically connected to the front-side first conductive element 322 through the connection element 35, a right-side second conductive element 333 electrically connected to the right-side first conductive element 323 through the connection element 35, and a rear-side second conductive element 334 electrically connected to the rear-side first conductive element 324 through the connection element 35) corresponding to and electrically connected to the plurality of first conductive elements, respectively. As shown in FIG. 3, a specific configuration of the second top metal interconnection structure on the second signal via group 21 is the same as that of the first top metal interconnection structure.

In some embodiments, each of the plurality of first conductive elements includes a first end and a second end, the first end being arranged opposite to the second end along an extension direction of said each of the plurality of first conductive elements, and each of the plurality of second conductive elements includes a third end and a fourth end, the third end being arranged opposite to the fourth end along an extension direction of said each of the plurality of second conductive elements.

The first end of each of the plurality of first conductive elements corresponds to and is electrically connected to the respective one of the plurality of signal vias.

For each of the plurality of second conductive elements and the respective one of the plurality of first conductive elements, an end of a respective one of the plurality of connection elements 35 is electrically connected to the third end of said each of the plurality of second conductive elements, and another end of the respective one of the plurality of connection elements is electrically connected to the second end of the respective one of the plurality of first conductive elements.

For example, as shown in FIG. 2 and FIG. 3, each of the left-side first conductive element 321 and the right-side first conductive element 323 in the first conductive layer extends in the second direction D2. **In** the second direction D2, each of the left-side first conductive element 321 and the right-side first conductive element 323 includes a first end and a second end arranged opposite to each other in the second direction D2. Each of the front-side first conductive element 322 and the rear-side first conductive element 324 extends in the first direction D1. Each of the front-side first conductive element 322 and the rear-side first conductive element 324 includes a first end and a second end arranged opposite to each other in the first direction D1. In any two first conductive elements arranged adjacent to each other along the counterclockwise direction or the clockwise direction in the first conductive layer, the first end of one of the two first conductive elements is arranged adjacent to but is not connected to the second end of another one of the two first conductive elements, so that the plurality of first conductive elements in the first conductive layer are arranged in the polygonal shape (for example, a square shape or a diamond shape) in a manner that head and tail ends face to each other (for example, the first end of the first conductive element is a head end, and the second end of the first conductive element is a tail end). Each of the left-side second conductive element 331 and the right-side second conductive element 333 in the second conductive layer extends in the second direction D2. Each of the left-side second conductive element 331 and the right-side second conductive element 333 includes a third end and a fourth end arranged opposite to each other in the second direction D2. Each of the front-side second conductive element 332 and the rear-side second conductive element 334 extends in the first direction D1. Each of the front-side second conductive element 332 and the rear-side second conductive element 334 includes a third end and a fourth end arranged opposite to each other in the first direction D1. In any two second conductive elements arranged adjacent to each other along the counterclockwise direction or the clockwise direction in the second conductive layer, the third end of one of the two second conductive elements is arranged adjacent to the fourth end of another one of the two second conductive elements, so that the plurality of second conductive elements in the second conductive layer are arranged in the polygonal shape (for example, a square shape or a diamond shape) in a manner that head and tail ends face to each other (for example, the third end of the second conductive element is a head end, and the fourth end of the second conductive element is a tail end). An end of the connection element 35 is electrically connected to the third end of the second conductive element, and another end of the connection element is electrically connected to the second end of the first conductive element. By adopting the above top metal interconnection structure including the first conductive layer and the second conductive layer, a specific structure of the top metal interconnection structure may be simplified, thereby reducing the manufacturing difficulty of the top metal interconnection structure. In an example, the top metal interconnection structure further includes an insulation dielectric layer arranged between the first conductive layer and the second conductive layer, for electrically isolating the first end of the first conductive element from the second conductive element.

In some embodiments, the semiconductor die further includes a plurality of internal circuits.

Each of the plurality of internal circuits corresponds to a respective one of the plurality of top metal interconnection structures, and each of the plurality of internal circuits is electrically connected to a respective one of the plurality of conductive paths in the respective one of the plurality of top metal interconnection structures.

In some embodiments, the semiconductor die further includes a plurality of lead-out wires.

Each of the plurality of lead-out wires corresponds to a respective one of the plurality of internal circuits. An end of each of the plurality of lead-out wires 50 is electrically connected to the respective one of the plurality of internal circuits, and another end of each of the plurality of lead-out wires 50 is only electrically connected to a respective one of the plurality of first conductive elements in the respective one of the plurality of top metal interconnection structures, so as to transmit control signals from outside to the internal circuits inside the semiconductor die through the lead-out wires.

For example, as shown in FIG. 1, the first signal via group 20 of a pair of signal via groups in the semiconductor die is electrically connected to a first internal circuit in the semiconductor die through a first lead-out wire 50, and the second signal via group is electrically connected to a second internal circuit in the semiconductor die through a second lead-out wire 51.

In some embodiments, each of the signal via groups includes four signal vias arranged in a square shape or a diamond shape. In other embodiments, each of the signal via groups may further include more than five signal vias, for example, each of the signal via groups includes five, six, seven or eight signal vias.

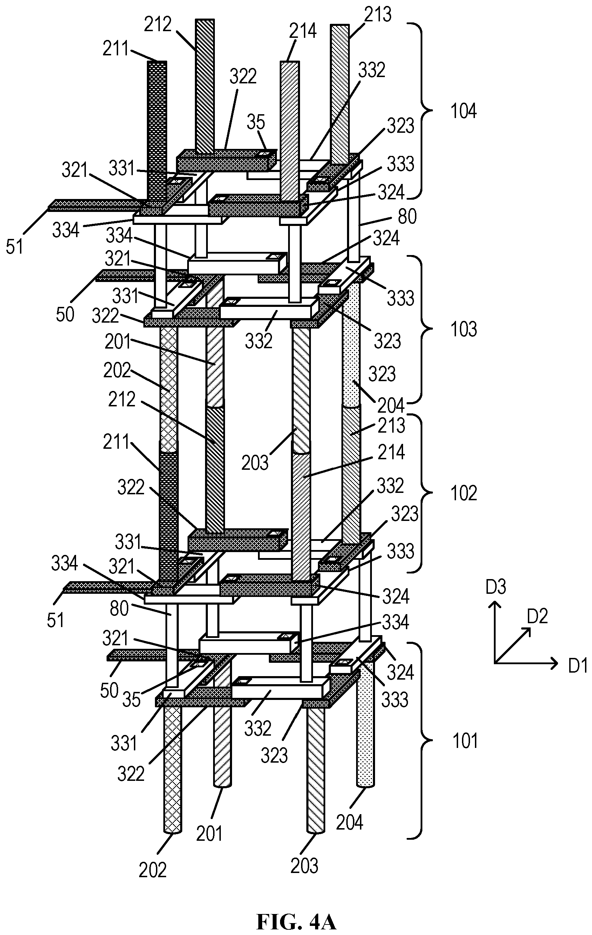

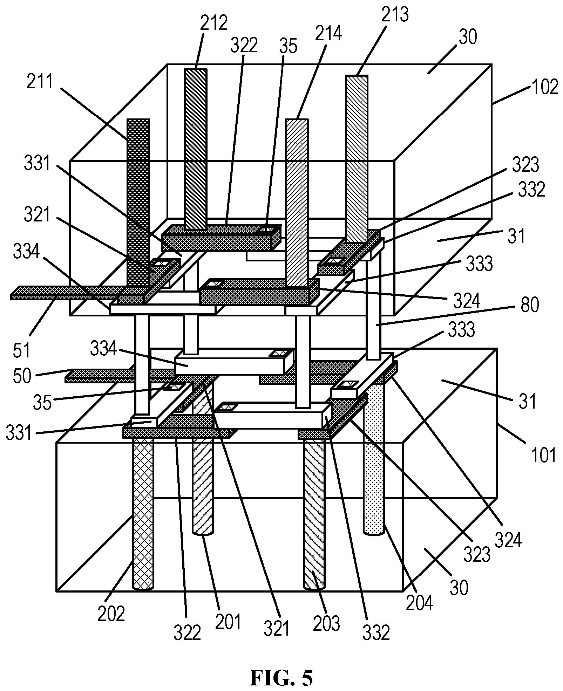

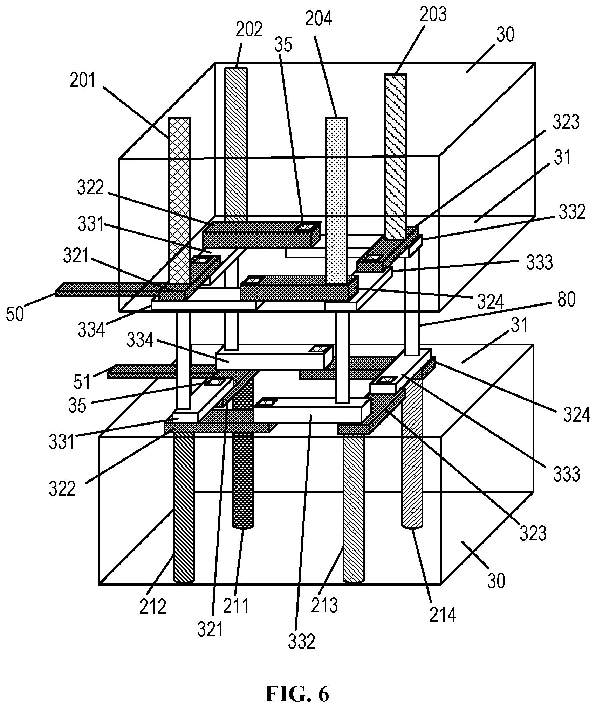

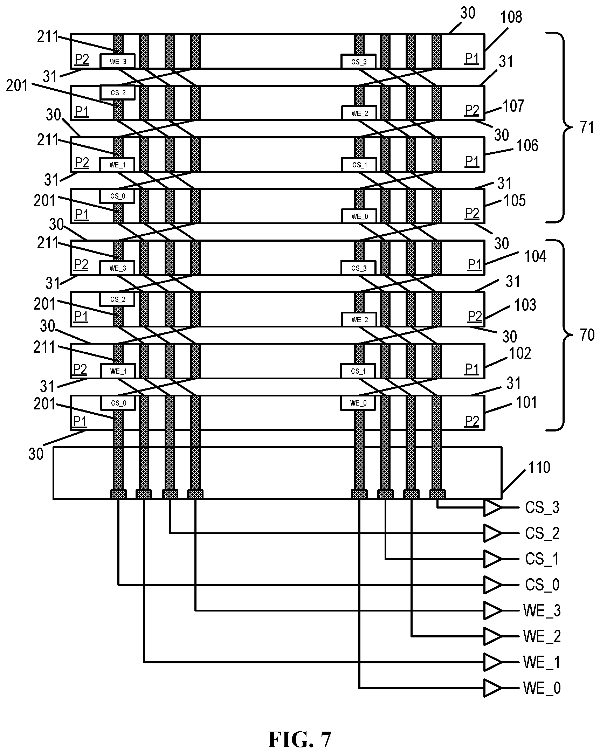

This specific implementations further provide a semiconductor device. FIG. 4A to FIG. 4C are schematic diagrams of a stack structure of a semiconductor device according to a specific implementation of the application, FIG. 5 is a schematic diagram of a structure after bonding a first region of a first semiconductor die to a second region of a second semiconductor die according to a specific implementation of the application, FIG. 6 is a schematic diagram of a structure after bonding a second region of a first semiconductor die to a first region of a second semiconductor die according to a specific implementation of the application, and FIG. 7 is a schematic cross-sectional view of a semiconductor device according to a specific implementation of the application. In FIG. 7, the first region P1 and the second region P2 in each semiconductor die are distributed symmetrically on opposite sides of the axis AA (with reference to FIG. 1). The axis AA is not visible in an viewing angle shown in FIG. 7. As shown in FIG. 4A and FIG. 7, the semiconductor device includes a base plate 110 and a stack structure.

The stack structure is located on the base plate 110, and includes N cell structures. The N cell structures are sequentially stacked on one another in the third direction D3 and are electrically connected to each other. Each of the N cell structures includes four semiconductor dies as described above, in which N is a positive integer.

The four semiconductor dies in each of the N cell structures are sequentially stacked on one another along the third direction D3. A first semiconductor die 101 at a bottommost layer is stacked face-to-face with a second semiconductor die 102 arranged above the first semiconductor die 101, the second semiconductor die 102 is stacked back-to-back with a third semiconductor die 103 arranged above the second semiconductor die 102, and the third semiconductor die 103 is stacked face-to-face with a fourth semiconductor die 104 arranged above the third semiconductor die 103.

Axes AA of any two adjacent semiconductor dies of a plurality of semiconductor dies in the stack structure are aligned with each other, and the first region P1 of one of the any two adjacent semiconductor dies is aligned with the second region P2 of another one of the any two adjacent semiconductor dies.

Face-to-face means that top surfaces of two adjacent semiconductor dies face towards each other, and back-to-back means that bottom surfaces of two adjacent semiconductor dies face towards each other.

With reference to FIG. 4A and FIG. 7, the first semiconductor die 101 at the bottommost layer being stacked face-to-face with the second semiconductor die 102 arranged above the first semiconductor die 101 means that the first semiconductor die 101 is stacked with the second semiconductor die 102 in a manner that the top surface 31 of the substrate 10 of the first semiconductor die 101 face towards the top surface 31 of the substrate 10 of the second semiconductor die 102. The second semiconductor die 102 being stacked back-to-back with the third semiconductor die 103 arranged above the second semiconductor die 102 means that the second semiconductor die 102 is stacked with the third semiconductor die 103 in a manner that the bottom surface 30 of the substrate 10 of the second semiconductor die 102 face towards the bottom surface 30 of the substrate 10 of the third semiconductor die 103. Each of the first semiconductor die 101, the second semiconductor die 102, the third semiconductor die 103 and the fourth semiconductor die 104 in this specific implementation has the same structure as the semiconductor die shown in FIG. 1 to FIG. 3. This specific implementation shows only two cell structures, i.e., a first cell structure 70 including the first semiconductor die 101, the second semiconductor die 102, the third semiconductor die 103 and the fourth semiconductor die 104, and a second cell structure 71 including a fifth semiconductor die 105, a sixth semiconductor die 106, a seventh semiconductor die 107 and an eighth semiconductor die 108. The axes AA of any two adjacent cell structures (for example, the first cell structure 70 and the second cell structure 71) in the stack structure are aligned with each other, and the axes AA of any two adjacent semiconductor dies (for example, the first semiconductor die 101 and the second semiconductor die 102 in the first cell structure 70) in each of the cell structures (for example, the first cell structure 70 and the second cell structure 71) are aligned with each other, that is, the axes AA of any two adjacent semiconductor dies in the stack structure are aligned with each other.

According to this specific implementation, a pair of signal via groups distributed symmetrically with respect to the axis AA are formed, and each of two signal via groups in each pair of signal via groups includes the plurality of signal vias arranged in the polygonal shape, so that it is unnecessary to change the manufacturing processes of a single semiconductor die when the plurality of semiconductor dies are stacked on the base plate 110, thereby simplifying the process flows of the semiconductor die. Furthermore, in some embodiments of this specific implementation, control signals are sequentially transmitted to the plurality of semiconductor dies in the semiconductor device through an interface circuit in the base plate, so that it is unnecessary to provide a driver and an interface circuit for each of the semiconductor dies individually, which simplifies the driving operations of the semiconductor device, and may reduce the driving load of the semiconductor device, increase the data eye diagram and reduce the power consumption of the semiconductor device. Furthermore, in some embodiments of this specific implementation, two signal via groups in a pair of signal via groups are independent of each other, so that different control signals may be simultaneously transmitted to the two signal via groups in a pair of signal via groups through the interface circuit in the base plate without simultaneously driving the two signal via groups, thereby improving the driving efficiency of the semiconductor device, and simplifying the driving operations of the semiconductor device.

In some embodiments, the semiconductor device further includes a plurality of pairs of signal transmission link groups.

Each pair of the plurality of pairs of signal transmission link groups correspond to a respective one of the plurality of pairs of signal via groups in each of the plurality of semiconductor dies. Each of a plurality of signal transmission link groups includes a plurality of signal transmission links, the plurality of signal transmission links in each of the plurality of signal transmission link groups are independent of each other and each spirally extend along the third direction D3. Each of the plurality of signal transmission links in each of the plurality of signal transmission link groups correspond to a respective one of the plurality of signal vias in a respective one of the plurality of signal via groups in each of the plurality of semiconductor dies, and each of the plurality of signal transmission links includes the respective one of the plurality of signal vias in each of the plurality of semiconductor dies.

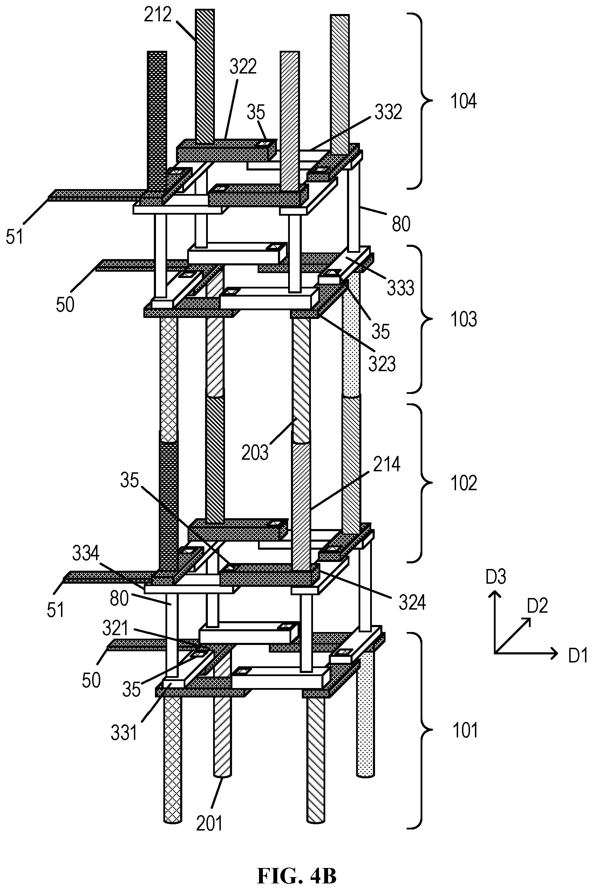

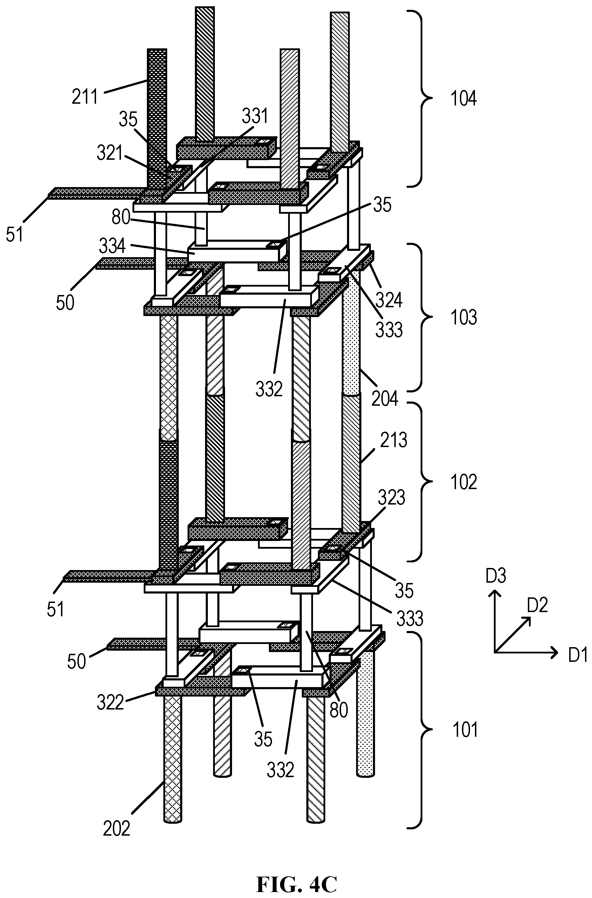

Specifically, each pair of the plurality of pairs of signal transmission link groups correspond to the respective one of the plurality of signal via groups in each semiconductor die, each pair of the signal transmission link groups includes two signal transmission link groups each corresponding to a respective one of two signal via groups in each pair of signal via groups, each of the signal transmission link groups includes the plurality of signal transmission links each corresponding to the respective one of the plurality of signal vias in the respective one of the signal via groups, and each of the signal transmission links includes a signal vias corresponding thereto in each of the semiconductor dies. For example, as shown in FIG. 4B, one signal transmission link includes the first signal via 201 in the first semiconductor die 101, the eighth signal via 214 in the second semiconductor die 102, the third signal via 203 in the third semiconductor die 103, and the sixth signal via 212 in the fourth semiconductor die 104. For example, as shown in FIG. 4C, another signal transmission link includes the second signal via 202 in the first semiconductor die 101, the seventh signal via 213 in the second semiconductor die 102, the fourth signal via 204 in the third semiconductor die 103, and the fifth signal via 211 in the fourth semiconductor die 104. The plurality of signal transmission links in the signal transmission link group are independent of each other and spirally extend along the third direction D3, so that signal crosstalk between the signal transmission links is avoided.

In some embodiments, in two semiconductor dies stacked face-to-face with each other, projections of the signal vias in two semiconductor dies electrically connected to the same signal line transmission link on the top surface of any substrate are centrosymmetrically distributed, and the symmetric center is a projection of a polygon on the top surface of the substrate. In an example, in any two signal transmission links in a signal transmission link group, a virtual straight line connected between two signal vias on one of the signal transmission links has a first angle with a center line of the stack structure, and a virtual straight line connected between two signal vias on another one of the signal transmission links has a second angle with the center line of the stack structure, and the first angle is equal to the second angle.

In some embodiments, each of the plurality of signal transmission link groups further includes a plurality of pairs of bonding pillar groups.

The plurality of pairs of bonding pillar groups are located only between any two adjacent semiconductor dies stacked face-to-face with each other. Each pair of the plurality of pairs of bonding pillar groups correspond to a respective one of the plurality of pairs of signal via groups in each of the any two adjacent semiconductor dies stacked face-to-face with each other, to implement signal transmission between the any two adjacent semiconductor dies stacked face-to-face with each other. Each of the plurality of bonding pillar groups includes a plurality of bonding pillars 80. Each of the plurality of bonding pillars 80 corresponds to a respective one of the plurality of signal vias in each of the any two adjacent semiconductor dies stacked face-to-face with each other. Each pair of the plurality of pairs of signal transmission link groups corresponds to a respective one of the plurality of pairs of bonding pillar groups located between the any two adjacent semiconductor dies stacked face-to-face with each other. Each of the plurality of signal transmission links in each of the plurality of signal transmission link groups corresponds to a respective one of the plurality of bonding pillars 80 in the respective one of the plurality of pairs of bonding pillar groups, and each of the plurality of signal transmission links includes the respective one of the plurality of bonding pillars 80 arranged between the any two adjacent semiconductor dies stacked face-to-face with each other.

For example, as shown in FIG. 5, there is a bonding pillar group between the first semiconductor die 101 and the second semiconductor die 102 stacked face-to-face with each other. Four bonding pillars 80 in the bonding pillar group correspond to four signal vias (i.e., the first signal via 201, the second signal via 202, the third signal via 203 and the fourth signal via 204) in the first semiconductor die 101, respectively, and correspond to four signal vias (i.e., the fifth signal via 211, the sixth signal via 212, the seventh signal via 213 and the eighth signal via 214) in the second semiconductor die 102, respectively. For example, in the structure shown in FIG. 5, one signal transmission link includes the first signal via 201 in the first semiconductor die 101, the eighth signal via 214 in the second semiconductor die 102, and the bonding pillar 80 for electrically connecting the first signal via 201 in the first semiconductor die 101 with the eighth signal via 214 in the second semiconductor die 102.

In some embodiments, in two adjacent semiconductor dies stacked back-to-back with each other, each of the plurality of signal vias in one of the two adjacent semiconductor dies corresponds to and is electrically connected with a respective one of the plurality of signal vias in another one of the two adjacent semiconductor dies.

For example, as shown in FIG. 4B, in the second semiconductor die 102 and the third semiconductor die 103 stacked back-to-back with each other, the eighth signal via 214 in the second semiconductor die 102 is electrically connected with the third signal via 203 in the third semiconductor die 103. For example, as shown in FIG. 4C, in the second semiconductor die 102 and the third semiconductor die 103 stacked back-to-back with each other, the seventh signal via 213 in the second semiconductor die 102 is electrically connected with the fourth signal via 204 in the third semiconductor die 103.

In some embodiments, each of the plurality of semiconductor dies includes a plurality of top metal interconnection structures. The plurality of top metal interconnection structures are located on the top surface of the substrate 10. Each of the plurality of top metal interconnection structures corresponds to and is electrically connected to a respective one of the plurality of signal via groups. Each of the plurality of top metal interconnection structures includes a plurality of conductive paths. Each of the plurality of conductive paths corresponds to and is electrically connected to a respective one of the plurality of signal vias in the respective one of the plurality of signal via groups, and each of the plurality of signal transmission links includes a respective one of the plurality of signal vias and a respective one of the plurality of conductive paths in each of the plurality of semiconductor dies.

Each of the plurality of top metal interconnection structures includes a first conductive layer, a second conductive layer, and a plurality of connection elements 35. The first conductive layer is located on the top surface of the substrate and includes a plurality of first conductive elements spaced apart from each other. The plurality of first conductive elements are arranged in the polygonal shape, and each of the plurality of first conductive elements corresponds to and is electrically connected to a respective one of the plurality of signal vias in the respective one of the plurality of signal via groups. The second conductive layer is located on the first conductive layer and includes a plurality of second conductive elements spaced apart from each other. Each of the plurality of second conductive elements corresponds to a respective one of the plurality of first conductive elements. The plurality of second conductive elements are arranged in the polygonal shape, and a portion of each of the plurality of second conductive elements is overlapped with a portion of the respective one of the plurality of first conductive elements. Each of the plurality of connection elements correspond to a respective one of the plurality of first conductive elements and a respective one of the plurality of second conductive elements, and each of the plurality of connection elements is configured to electrically connect the respective one of the plurality of first conductive elements with the respective one of the plurality of second conductive elements, to form a respective one of the plurality of conductive paths.

Each of the plurality of first conductive elements includes a first end and a second end, the first end being arranged opposite to the second end along an extension direction of said each of the plurality of first conductive elements. Each of the plurality of second conductive elements includes a third end and a fourth end, the third end being arranged opposite to the fourth end along an extension direction of said each of the plurality of second conductive elements. The first end of each of the plurality of first conductive elements corresponds to and is electrically connected to the respective one of the plurality of signal vias. For each of the plurality of second conductive elements and the respective one of the plurality of first conductive element, an end of a respective one of the plurality of connection elements 35 is electrically connected to the third end of said each of the plurality of second conductive elements, and another end of the respective one of the plurality of connection elements is electrically connected to the second end of the respective one of the plurality of first conductive elements.

In some embodiments, for the any two adjacent semiconductor dies stacked face-to-face with each other, each pair of the plurality of pairs of bonding pillar groups corresponds to a respective one of the plurality of top metal interconnection structures of each of the any two adjacent semiconductor dies stacked face-to-face with each other, an end of each of the plurality of bonding pillars 80 is electrically connected to the fourth end of a respective one of the plurality of second conductive elements in one of the any two adjacent semiconductor dies stacked face-to-face with each other, and another end of each of the plurality of bonding pillars 80 is electrically connected to the fourth end of a respective one of the plurality of second conductive elements in another one of the any two adjacent semiconductor dies stacked face-to-face with each other.

Specifically, structures of four semiconductor dies (i.e., the first semiconductor die 101, the second semiconductor die 102, the third semiconductor die 103 and the fourth semiconductor die 104) in the cell structure are the same, so that face-to-face bonding of the semiconductor dies may be achieved by just performing simple rotation (for example, flipping) operations. For example, each of the plurality of second conductive elements in the first semiconductor die 101 corresponds to and is bonded to a respective one of the plurality of second conductive elements in the second semiconductor die 102 through the bonding pillars 80. Each of the plurality of signal vias in the second semiconductor die 102 corresponds to and is electrically connected with a respective one of the plurality of signal vias in the third semiconductor die 103.

For example, as shown in FIG. 4A and FIG. 5, the top metal interconnection structure in the first semiconductor die 101 electrically connected to the first signal via group 20 includes four conductive paths, i.e., a first conductive path, a second conductive path, a third conductive path and a fourth conductive path. The first conductive path in the first semiconductor die 101 is composed of the left-side first conductive element 321, the connection element 35 electrically connecting the left-side first conductive element 321 with the left-side second conductive element 331, and the left-side second conductive element 331, which are sequentially electrically connected to each other. The second conductive path in the first semiconductor die 101 is composed of the front-side first conductive element 322, the connection element 35 electrically connecting the front-side first conductive element 322 with the front-side second conductive element 332, and the front-side second conductive element 332, which are sequentially electrically connected to each other. The third conductive path in the first semiconductor die 101 is composed of the right-side first conductive element 323, the connection element 35 electrically connecting the right-side first conductive element 323 with the right-side second conductive element 333, and the right-side second conductive element 333, which are sequentially electrically connected to each other. The fourth conductive path in the first semiconductor die 101 is composed of the rear-side first conductive element 324, the connection element 35 electrically connecting the rear-side first conductive element 324 with the rear-side second conductive element 334, and the rear-side second conductive element 334, which are sequentially electrically connected to each other. The top metal interconnection structure in the first semiconductor die 101 electrically connected to the second signal via group 21 also includes four conductive paths, i.e., a first conductive path, a second conductive path, a third conductive path and a fourth conductive path. Furthermore, the top metal interconnection structure in the first semiconductor die 101 electrically connected to the first signal via group 20 is the same as the top metal interconnection structure in the first semiconductor die 101 electrically connected to the second signal via group 21, with reference to FIG. 4A and FIG. 6.

As shown in FIG. 4A and FIG. 5, one signal transmission link includes the first signal via 201 in the first semiconductor die 101, the first conductive path in the first semiconductor die 101, the bonding pillar 80 electrically connecting the first conductive path in the first semiconductor die 101 with the fourth conductive path in the second semiconductor die 102, the fourth conductive path in the second semiconductor die 102, and the eighth signal via 214 in the second semiconductor die 102.

In some embodiments, each of the plurality of semiconductor dies further includes a plurality of internal circuits and a plurality of lead-out wires 50.

Each of the plurality of internal circuits corresponds to a respective one of the plurality of top metal interconnection structures, and each of the plurality of internal circuits is electrically connected to a respective one of the plurality of conductive paths in the respective one of the plurality of top metal interconnection structures.

Each of the plurality of lead-out wires 50 corresponds to a respective one of the plurality of internal circuits. An end of each of the plurality of lead-out wires 50 is electrically connected to the respective one of the plurality of internal circuits, and another end of each of the plurality of lead-out wires 50 is only electrically connected to a respective one of the plurality of first conductive elements in the respective one of the plurality of top metal interconnection structures.

In some embodiments, for each of the cell structures, one of the plurality of signal transmission links is only electrically connected to one of the plurality of lead-out wires in one of the plurality of semiconductor dies.

For example, as shown in FIG. 4A and FIG. 5, the first semiconductor die 101 includes the left-side first conductive element 321 electrically connected to the first signal via group 20, and a first lead-out wire 50 electrically connected to the left-side first conductive element 201. The first lead-out wire 50 is located in the first region P1 of the first semiconductor die 101 (with reference to FIG. 1). As shown in FIG. 6, the first semiconductor die 101 further includes the left-side first conductive element 321 electrically connected to the second signal via group 21, and a second lead-out wire 51 electrically connected to the left-side first conductive element 201. The second lead-out wire 51 is located in the second region P2 of the first semiconductor die 101 (with reference to FIG. 1). The first lead-out wire 50 in the first semiconductor die 101 is electrically connected to a first internal circuit (not shown in the figures) inside the first semiconductor die 101, and the second lead-out wire 51 in the first semiconductor die 101 is electrically connected to a second internal circuit (not shown in the figures) inside the first semiconductor die 101.

In some embodiments, the semiconductor device further includes an interface circuit.

The interface circuit is located in the base plate 110 and is electrically connected to the plurality of pairs of signal transmission link groups. The interface circuit is configured to transmit a plurality of control signals to the plurality of signal transmission link groups, each of the plurality of control signals corresponding to a respective one of the plurality of signal transmission links in the plurality of signal transmission link groups, and each of the plurality of control signals being only led out from one of the plurality of lead-out wires in one of the plurality of semiconductor dies in each of the cell structures.

For each pair of the plurality of pairs of signal via groups in one of the plurality of semiconductor dies, the interface circuit outputs a first control signal to a lead-out wire electrically connected to one of the plurality of signal vias in one of the plurality of signal via groups through a respective one of the plurality of signal transmission links, and transmits a second control signal, which is different from the first control signal, to a lead-out wire electrically connected to one of the plurality of signal vias in another one of the plurality of signal via groups through another respective one of the plurality of signal transmission links.

For example, as shown in FIG. 7, for two signal transmission link groups in each pair of signal transmission link groups, the interface circuit transmits, to one of the signal transmission link groups, four first sub-control signals (i.e., a CS_0 signal, a CS_2 signal, a WE_1 signal, and a WE_3 signal) each corresponding to a respective one of four signal transmission links in one of the signal transmission link groups, and the interface circuit transmits, to another one of the signal transmission link groups, four second sub-control signals (i.e., a CS_1 signal, a CS_3 signal, a WE_0 signal, and a WE_2 signal) each corresponding to a respective one of four signal transmission links in another one of the signal transmission link groups. For a pair of signal via groups composed of the first signal via group 20 and the second signal via group 21 in one of the semiconductor dies, the interface circuit outputs the CS_0 signal to the first lead-out wire in the semiconductor die through the first signal via group 20, so that the CS_0 signal is transmitted to the first internal circuit in the semiconductor die; and the interface circuit outputs the WE_0 signal to the second lead-out wire 51 in the semiconductor die through the second signal via group 21, so that the WE_0 signal is transmitted to the second internal circuit in the semiconductor die. As shown in FIG. 4B and FIG. 7, the signal transmission link transmitting the CS_0 signal is only electrically connected to the first lead-out wire 50 in the first semiconductor die 101 in the first cell structure 70.

For example, as shown in FIG. 4A and FIG. 7, the CS_0 signal is transmitted to the first signal via 201 in the first semiconductor die 101 in the first cell structure 70 through the interface circuit in the base plate, and is output to the first internal circuit inside the first semiconductor die 101 by sequentially passing through the left-side first conductive element 321 electrically connected to the first signal via 201 and the first lead-out wire 50. The WE_1 signal is transmitted to the first cell structure 70 through the interface circuit in the base plate, transmitted to the second semiconductor die 102 through the first semiconductor die 101 in the first cell structure 70, transmitted to the second lead-out wire 51 in the second semiconductor die 102 through the fifth signal via in the second semiconductor die 102, and is output to the second internal circuit in the second semiconductor die 102 through the second lead-out wire 51. The CS_2 signal is transmitted to the first cell structure 70 through the interface circuit in the base plate, transmitted to the third semiconductor die 103 through the first semiconductor die 101 and the second semiconductor die 102 in the first cell structure 70, transmitted to the first lead-out wire 50 in the third semiconductor die 103 through the first signal via in the third semiconductor die 103, and is output to the first internal circuit in the third semiconductor die 103 through the first lead-out wire 50. The WE_3 signal is transmitted to the first cell structure 70 through the interface circuit in the base plate, transmitted to the fourth semiconductor die 104 after passing through the first semiconductor die 101, the second semiconductor die 102 and the third semiconductor die 103 in the first cell structure 70, transmitted to the second lead-out wire 51 in the fourth semiconductor die 104 through the fifth signal via in the fourth semiconductor die 104, and is output to the second internal circuit in the fourth semiconductor die 104 through the second lead-out wire 51. By analogy, the interface circuit in the base plate transmits, through the signal transmission links, the respective first sub-control signal and the respective second sub-control signal to the respective semiconductor dies of other cell structures in the stack structure respectively, such as semiconductor dies 105 to 108 in the second cell structure 71 in FIG. 7,.

The plurality of signal transmission links in the signal transmission link group being independent of each other and spirally extending along the third direction D3 are exemplified below.

In particular, as shown in FIG. 4B, one signal transmission link in the stack structure includes the first signal via 201 in the first semiconductor die 101 in one of the cell structures, the left-side first conductive element 321 in the first semiconductor die 101, the connection element 35 in the first semiconductor die 101 electrically connecting the left-side first conductive element 321 with the left-side second conductive element 331, the left-side second conductive element 331 in the first semiconductor die, the bonding pillar 80 arranged between the first semiconductor die 101 and the second semiconductor die 102 stacked face-to-face with each other, the rear-side second conductive element 334 in the second semiconductor die 102, the connection element 35 in the second semiconductor die 102 electrically connecting the rear-side second conductive element 334 with the rear-side first conductive element 324, the rear-side first conductive element 324 in the second semiconductor die 102, the eighth signal via 214 in the second semiconductor die 102, the third signal via 203 in the third semiconductor die 103, the right-side first conductive element 323 in the third semiconductor die 103, the connection element 35 in the third semiconductor die 103 electrically connecting the right-side first conductive element 323 with the right-side second conductive element 333, the right-side second conductive element 333 in the third semiconductor die 103, the bonding pillar 80 arranged between the third semiconductor die 103 and the fourth semiconductor die 104, the front-side second conductive element 332 in the fourth semiconductor die 104, the connection element 35 in the fourth semiconductor die 104 electrically connecting the front-side second conductive element 332 with the front-side first conductive element 322, the front-side first conductive element 322 in the fourth semiconductor die 104, and the sixth signal via 212 in the fourth semiconductor die 104.

The stack structure transmits a respective control signal between dies through each of the signal transmission links. With reference to FIG. 4B and FIG. 7, after the CS_0 signal from outside is transmitted to the first signal via 201 in the first semiconductor die 101 in one of the cell structures through the interface circuit in the base plate 110, the CS_0 signal is transmitted to the bonding pillar 80 by sequentially passing through the left-side first conductive element 321 electrically connected to the first signal via 201, the connection element 35 and the left-side second conductive element 331 in the first semiconductor die 101, transmitted to the rear-side second conductive element 334 in the second semiconductor die 102 through the bonding pillar 80, then transmitted to the eighth signal via 214 in the second semiconductor die 102 by sequentially passing through the connection element 35 and the rear-side first conductive element 324 in the second semiconductor die 102, then transmitted to the top metal interconnection structure of the third semiconductor die 103 through the third signal via 203 in the third semiconductor die 103 electrically connected to the eighth signal via 214 in the second semiconductor die 102, transmitted to the bonding pillar 80 by sequentially passing through the right-side first conductive element 323, the connection element 35 and the right-side second conductive element 333 in the third semiconductor die 103, transmitted to the fourth semiconductor die 104 through the bonding pillar 80, and transmitted to a next cell structure by sequentially passing through the front-side second conductive element 332, the connection element 35, the front-side first conductive element 322 and the sixth signal via 212 in the fourth semiconductor die 104. That is, the same type of control signal is spirally transmitted upward along an independent signal transmission path.

For example, as shown in FIG. 4C and FIG. 7, another signal transmission link in the stack structure includes the second signal via 202 in the first semiconductor die 101 in one of the cell structures, the front-side first conductive element 322 in the first semiconductor die 101, the connection element 35 in the first semiconductor die 101 electrically connecting the front-side first conductive element 322 with the front-side second conductive element 332, the front-side second conductive element 332 in the first semiconductor die 101, the bonding pillars 80 in the first semiconductor die 101 and the second semiconductor die 102, the right-side second conductive element 333 in the second semiconductor die 102, the connection element 35 in the second semiconductor die 102 electrically connecting the right-side second conductive element 333 with the right-side first conductive element 323, the right-side first conductive element 323 in the second semiconductor die 102, the seventh signal via 213 in the second semiconductor die 102, the fourth signal via 204 in the third semiconductor die 103, the rear-side first conductive element 324 in the third semiconductor die 103, the connection element 35 in the third semiconductor die 103 electrically connecting the rear-side first conductive element 324 with the right-side second conductive element 334, the rear-side second conductive element 334 in the third semiconductor die 103, the bonding pillar 80 arranged between the third semiconductor die 103 and the fourth semiconductor die 104, the left-side second conductive element 331 in the fourth semiconductor die 104, the connection element 35 in the fourth semiconductor die 104 electrically connecting the left-side second conductive element 331 with the left-side first conductive element 321, the left-side first conductive element 321 in the fourth semiconductor die 104, and the fifth signal via 211 in the fourth semiconductor die 104.

With reference to FIG. 4C and FIG. 7, after the WE_1 signal from outside is transmitted to the second signal via 202 in the first semiconductor die 101 through the interface circuit in the base plate 110, the WE_1 signal is transmitted to the bonding pillar 80 by sequentially passing through the front-side first conductive element 322 electrically connected to the second signal via 202, the connection element 35 and the front-side second conductive element 332 in the first semiconductor die 101, transmitted to the right-side second conductive element 333 in the second semiconductor die 102 through the bonding pillar 80, transmitted to the seventh signal via 213 in the second semiconductor die 102 through the connection element 35 and the right-side first conductive element 323, then transmitted to the top metal interconnection structure of the third semiconductor die 103 through the fourth signal via 204 in the third semiconductor die 103 electrically connected to the seventh signal via 213 in the second semiconductor die 102, transmitted to the bonding pillar 80 by sequentially passing through the rear-side first conductive element 324, the connection element 35 and the rear-side second conductive element 334 in the third semiconductor die 103, transmitted to the fourth semiconductor die 104 through the bonding pillar 80, and transmitted to a next cell structure by sequentially passing through the left-side second conductive element 331, the connection element 35, the left-side first conductive element 321 and the fifth signal via 211 in the fourth semiconductor die 104. That is, the same type of control signal is spirally transmitted upward along an independent signal transmission path.

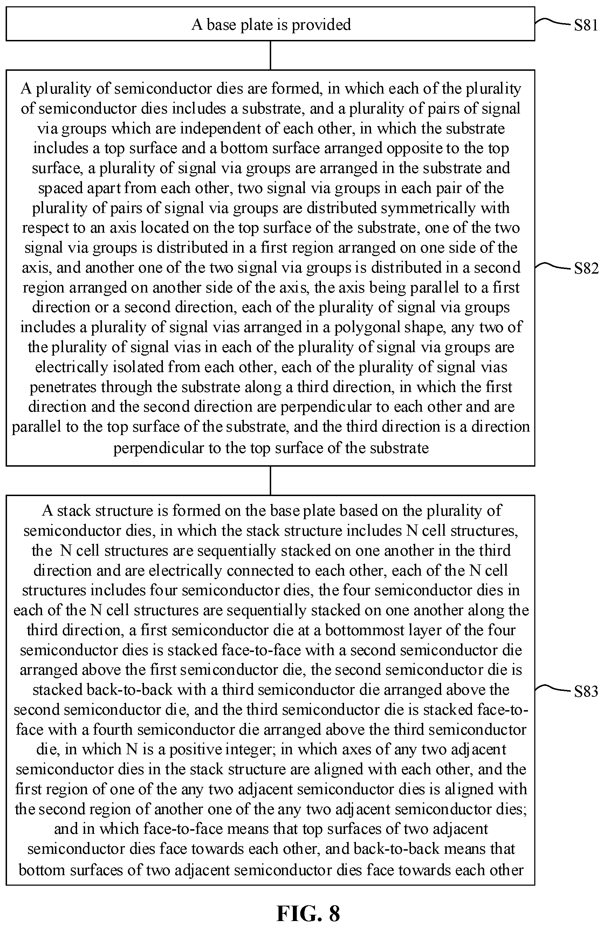

This specific implementation further provides a method for forming a semiconductor device. FIG. 8 is a flowchart of a method for forming a semiconductor device according to a specific implementation of the application. Structures of the semiconductor device formed in this specific implementation may refer to FIG. 1 to FIG. 7. As shown in FIG. 1 to FIG. 8, the method for forming a semiconductor device includes the following operations.

In operation S81, a base plate 110 is provided.

In operation S82, a plurality of semiconductor dies are formed. Each of the plurality of semiconductor dies includes a substrate 10, and a plurality of pairs of signal via groups which are independent of each other. The substrate 10 includes a top surface 31 and a bottom surface 30 arranged opposite to the top surface 31. A plurality of signal via groups are arranged in the substrate and spaced apart from each other. Two signal via groups in each pair of the plurality of pairs of signal via groups are distributed symmetrically with respect to an axis AA located on the top surface of the substrate 10, one of the two signal via groups is distributed in a first region P1 arranged on one side of the axis, and another one of the two signal via groups is distributed in a second region P2 on another side of the axis. The axis AA is parallel to a first direction D1 or a second direction D2. Each of the plurality of signal via groups includes a plurality of signal vias 111 arranged in a polygonal shape. Any two of the plurality of signal vias 111 in each of the plurality of signal via groups are electrically isolated from each other. Each of the plurality of signal vias 111 penetrates through the substrate 10 along a third direction D3. The first direction D1 and the second direction D2 are perpendicular to each other and are parallel to the top surface 31, and the third direction D3 is a direction perpendicular to the top surface 31 of the substrate 10.

In operation S83, a stack structure is formed on the base plate 110 based on the plurality of semiconductor dies. The stack structure includes N cell structures, the N cell structures are sequentially stacked on one another along the third direction D3 and are electrically connected to each other. Each of the N cell structures includes four semiconductor dies. The four semiconductor dies in each of the N cell structures are sequentially stacked on one another along the third direction D3. A first semiconductor die 101 at a bottommost layer of the four semiconductor dies is stacked face-to-face with a second semiconductor die 102 arranged above the first semiconductor die 101, the second semiconductor die 102 is stacked back-to-back with a third semiconductor die 103 arranged above the second semiconductor die 102, and the third semiconductor die 103 is stacked face-to-face with a fourth semiconductor die 104 arranged above the third semiconductor die 103, in which N is a positive integer.

Axes AA of any two adjacent semiconductor dies of the plurality of semiconductor dies in the stack structure are aligned with each other, and the first region P1 of one of the any two adjacent semiconductor dies is aligned with the second region P2 of another one of the any two adjacent semiconductor dies.

Here face-to-face means that top surfaces of two adjacent semiconductor dies face towards each other, and back-to-back means that bottom surfaces of two adjacent semiconductor dies face towards each other.

In some embodiments, the operation that the plurality of semiconductor dies are formed includes the following specific operations.

The substrate 10 is formed, and the first region P1 arranged on said one side of the axis AA and the second region P2 arranged on the other side of the axis AA are defined in the substrate 10.

The plurality of signal via groups penetrating through the substrate 10 along the third direction D2 are formed in each of the first region P1 and the second region P2.

A plurality of top metal interconnection structures are formed on the top surface 31 of the substrate 10, in which each of the plurality of top metal interconnection structures corresponds to and is electrically connected to a respective one of the plurality of signal via groups, each of the plurality of top metal interconnection structures includes a plurality of conductive paths, each of the plurality of conductive paths corresponds to and is electrically connected to a respective one of the plurality of signal vias 111 in the respective one of the plurality of signal via groups.

In some embodiments, the operation that the plurality of top metal interconnection structures are formed on the top surface of the substrate includes the following specific operations.

A first conductive layer is formed on the top surface 31 of the substrate 10, in which the first conductive layer includes a plurality of first conductive elements spaced apart from each other, the plurality of first conductive elements are arranged in the polygonal shape, each of the plurality of first conductive elements includes a first end and a second end, the first end is arranged opposite to the second end along an extension direction of said each of the plurality of first conductive elements, and the first end of each of the plurality of first conductive elements corresponds to and is electrically connected to a respective one of the plurality of signal vias 111 in a respective one of the plurality of signal via groups.

A second conductive layer is formed above the first conductive layer, in which the second conductive layer includes a plurality of second conductive elements spaced apart from each other, each of the plurality of second conductive elements corresponds to a respective one of the plurality of first conductive elements, the plurality of second conductive elements are arranged in the polygonal shape, each of the plurality of second conductive elements includes a third end and a fourth end, the third end being arranged opposite to the fourth end along an extension direction of said each of the plurality of second conductive elements, and a portion of each of the plurality of second conductive elements is overlapped with a portion of the respective one of the plurality of first conductive elements.

A plurality of connection element 35 are formed between the first conductive layer and the second conductive layer, in which for each of the plurality of second conductive elements and the respective one of the plurality of first conductive element, an end of a respective one of the plurality of connection elements is electrically connected to the third end of said each of the plurality of second conductive elements, and another end of the respective one of the plurality of connection elements is electrically connected to the second end of the respective one of the plurality of first conductive elements, to form a respective one of the plurality of onductive paths.

In some embodiments, the operation that the stack structure is formed on the base plate 110 based on the plurality of semiconductor dies includes the following specific operations.

The four semiconductor dies are provided.

The first semiconductor die is placed on the base plate 110.

The second semiconductor die 102 is stacked above the first semiconductor die in a manner that the second semiconductor die is arranged face-to-face with the first semiconductor die.

The third semiconductor die 103 is stacked above the second semiconductor die 102 in a manner that the third semiconductor die is arranged back-to-back with the second semiconductor die.

The fourth semiconductor die 104 is stacked above the third semiconductor die 103 in a manner that the fourth semiconductor die is arranged face-to-face with the third semiconductor die, to form a cell structure including the first semiconductor die 101, the second semiconductor die 102, the third semiconductor die 103 and the fourth semiconductor die 104.

The above operations are repeated on the formed cell structure, to sequentially form the N cell structures stacked on one another along the third direction D3.

The axes AA of the any two adjacent semiconductor dies in the stack structure are aligned with each other, and the first region P1 of said one of the any two adjacent semiconductor dies is aligned with the second region P2 of the other one of the any two adjacent semiconductor dies.

In some embodiments, the operation that the second semiconductor die 102 is stacked above the first semiconductor die 101 in the manner that the second semiconductor die is arranged face-to-face with the first semiconductor die includes the following specific operations.

One of a plurality of bonding pillar group is formed on each of the plurality of top metal interconnection structures of the first semiconductor die 101, in which each of the plurality of bonding pillar groups includes a plurality of bonding pillars 80, a bottom end of each of the plurality of bonding pillars 80 is bonded and connected to the fourth end of a respective one of the plurality of second conductive elements in the first semiconductor die 101.

A top end of each of the plurality of bonding pillars is bonded and connected to a respective one of the plurality of top metal interconnection structures of the second semiconductor die 102, and the top end of each of the plurality of bonding pillars is bonded and connected to the fourth end of a respective one of the plurality of second conductive elements in the second semiconductor die 102.

In some embodiments, the operation that the third semiconductor die 103 is stacked above the second semiconductor die 102 in the manner that the third semiconductor die is arranged back-to-back with the second semiconductor die includes the following specific operations.

The plurality of signal vias 111 arranged in the second semiconductor die 102 contact or are electrically connected with a respective one of the plurality of signal vias 111 arranged in the third semiconductor die 103.

In some embodiments, each of the plurality of semiconductor dies further includes a plurality of internal circuits, each of the plurality of internal circuits corresponding to a respective one of the plurality of top metal interconnection structures. The method for forming the semiconductor device further includes the following operations.

A lead-out wire is formed between each of the plurality of internal circuits and the respective one of the plurality of top metal interconnection structures, to allow each of the plurality of internal circuits to be electrically connected to a respective one of the plurality of conductive paths in the respective one of the plurality of top metal interconnection structures.

In some embodiments, the method for forming the semiconductor device further includes the following operations.

An interface circuit is formed in the base plate 110.

The any two adjacent semiconductor dies in the stack structure are electrically connected with each other, to form a plurality of pairs of signal transmission link groups, each pair of the plurality of pairs of signal transmission link groups corresponding to a respective one of the plurality of pairs of signal via groups in each of the any two adjacent semiconductor dies, in which each of a plurality of signal transmission link groups includes a plurality of signal transmission links, each of the plurality of signal transmission links includes a respective one of the plurality of signal vias in each of the any two adjacent semiconductor dies, a respective one of the plurality of conductive paths in each of the any two adjacent semiconductor dies, and a respective one of the plurality of bonding pillars 80 arranged between the any two adjacent semiconductor dies stacked face-to-face with each other.

The interface circuit is electrically connected to the plurality of pairs of signal via groups in a semiconductor die at a bottommost layer of the stack structure, and the interface circuit is electrically connected to the plurality of pairs of signal transmission link groups to transmit a plurality of control signals to the plurality of signal transmission link groups, each of the plurality of control signals corresponding to a respective one of the plurality of signal transmission links in the plurality of signal transmission link groups, and each of the plurality of control signals being only led out to a respective one of the plurality of internal circuits through one lead-out wire in one of the plurality of semiconductor dies in each of the N cell structures; and in which for each pair of the plurality of pairs of signal via groups in one of the plurality of semiconductor dies, the interface circuit is further configured to output a first control signal to a lead-out wire electrically connected to one of the plurality of signal vias in one of the plurality of signal via groups through a respective one of the plurality of signal transmission links, and to transmit a second control signal, which is different from the first control signal, to a lead-out wire electrically connected to one of the plurality of signal vias in another one of the plurality of signal via groups through another respective one of the plurality of signal transmission links.

According to the semiconductor die, the semiconductor device and the method for forming the semiconductor device provided by some embodiments of this specific implementation, the plurality of pairs of signal via groups which are independent of each other are provided in the semiconductor die, the plurality of signal via groups are arranged in the substrate and spaced apart from each other, two signal via groups in each pair of signal via groups are distributed symmetrically with respect to an axis located on the top surface of the substrate, one of the two signal via groups is distributed in the first region arranged on one side of the axis, and another one of the two signal via groups is distributed in the second region on another side of the axis, so that when the plurality of semiconductor dies are stacked on one another, face-to-face stacking and connection of the semiconductor dies may be achieved by just performing simple rotation operations, thereby ensuring that the same control signal in the semiconductor device propagates upward in one direction, reducing the number of masks required in a process of forming the semiconductor device, simplifying the operation of sequentially stacking the plurality of semiconductor dies, reducing the manufacturing difficulty of the semiconductor device, and contributing to improving the yield of the semiconductor device.

The above descriptions are only preferred implementations of the application, and it should be noted that several modifications and embellishments may also be made by those of ordinary skill in the art without departing from principles of the application, and these modifications and embellishments should also be considered as the scope of protection of the application.

## Claims

1. A semiconductor die, comprising:
a substrate, wherein the substrate comprises a top surface and a bottom surface arranged opposite to the top surface; and
a plurality of pairs of signal via groups which are independent of each other, wherein a plurality of signal via groups are arranged in the substrate and spaced apart from each other, two signal via groups in each pair of the plurality of pairs of signal via groups are distributed symmetrically with respect to an axis located on the top surface of the substrate, one of the two signal via groups is distributed in a first region arranged on one side of the axis, and another one of the two signal via groups is distributed in a second region arranged on another side of the axis, the axis being parallel to a first direction or a second direction, each of the plurality of signal via groups comprises a plurality of signal vias arranged in a polygonal shape, any two of the plurality of signal vias in each of the plurality of signal via groups are electrically isolated from each other, each of the plurality of signal vias penetrates through the substrate along a third direction, wherein the first direction and the second direction are perpendicular to each other and are parallel to the top surface of the substrate, and the third direction is a direction perpendicular to the top surface of the substrate.

2. The semiconductor die according to claim 1, further comprising:
a plurality of top metal interconnection structures, wherein the plurality of top metal interconnection structures are located on the top surface of the substrate, and each of the plurality of top metal interconnection structures corresponds to and is electrically connected to a respective one of the plurality of signal via groups, each of the plurality of top metal interconnection structures comprises a plurality of conductive paths, each of the plurality of conductive paths corresponds to and is electrically connected to a respective one of the plurality of signal vias in the respective one of the plurality of signal via groups.

3. The semiconductor die according to claim 2, wherein each of the plurality of top metal interconnection structures comprises:
a first conductive layer, wherein the first conductive layer is located on the top surface of the substrate and comprises a plurality of first conductive elements spaced apart from each other, the plurality of first conductive elements are arranged in the polygonal shape, and each of the plurality of first conductive elements corresponds to and is electrically connected to a respective one of the plurality of signal vias in the respective one of the plurality of signal via groups;
a second conductive layer, wherein the second conductive layer is located on the first conductive layer and comprises a plurality of second conductive elements spaced apart from each other, each of the plurality of second conductive elements corresponds to a respective one of the plurality of first conductive elements, the plurality of second conductive elements are arranged in the polygonal shape, and a portion of each of the plurality of second conductive elements is overlapped with a portion of the respective one of the plurality of first conductive elements; and
a plurality of connection elements, wherein each of the plurality of connection elements corresponds to a respective one of the plurality of first conductive elements and a respective one of the plurality of second conductive elements, and each of the plurality of connection elements is configured to electrically connect the respective one of the plurality of first conductive elements with the respective one of the plurality of second conductive elements, to form a respective one of the plurality of conductive paths.

4. The semiconductor die according to claim 3, wherein each of the plurality of first conductive elements comprises a first end and a second end, the first end being arranged opposite to the second end along an extension direction of said each of the plurality of first conductive elements, and each of the plurality of second conductive elements comprises a third end and a fourth end, the third end being arranged opposite to the fourth end along an extension direction of said each of the plurality of second conductive elements;
wherein the first end of each of the plurality of first conductive elements corresponds to and is electrically connected to the respective one of the plurality of signal vias; and
wherein for each of the plurality of second conductive elements and the respective one of the plurality of first conductive elements, an end of a respective one of the plurality of connection elements is electrically connected to the third end of said each of the plurality of second conductive elements, and another end of the respective one of the plurality of connection elements is electrically connected to the second end of the respective one of the plurality of first conductive elements.

5. The semiconductor die according to claim 3, further comprising:
a plurality of internal circuits, wherein each of the plurality of internal circuits corresponds to a respective one of the plurality of top metal interconnection structures, and each of the plurality of internal circuits is electrically connected to a respective one of the plurality of conductive paths in the respective one of the plurality of top metal interconnection structures.

6. The semiconductor die according to claim 5, further comprising:
a plurality of lead-out wires, wherein each of the plurality of lead-out wires corresponds to a respective one of the plurality of internal circuits, an end of each of the plurality of lead-out wires is electrically connected to the respective one of the plurality of internal circuits, and another end of each of the plurality of lead-out wires is only electrically connected to a respective one of the plurality of first conductive elements in the respective one of the plurality of top metal interconnection structures.

7. The semiconductor die according to claim 1, wherein each of the plurality of signal via groups comprises four signal vias, and the four signal vias are arranged in a square shape or a diamond shape.

8. A semiconductor device, comprising:
a base plate; and
a stack structure, wherein the stack structure is located on the base plate and comprises N cell structures, the N cell structures are sequentially stacked on one another in the third direction and are electrically connected to each other, each of the N cell structures comprises four semiconductor dies according to claim 1, wherein N is a positive integer,
wherein the four semiconductor dies in each of the N cell structures are sequentially stacked on one another along the third direction, a first semiconductor die at a bottommost layer of the four semiconductor dies is stacked face-to-face with a second semiconductor die arranged above the first semiconductor die, the second semiconductor die is stacked back-to-back with a third semiconductor die arranged above the second semiconductor die, and the third semiconductor die is stacked face-to-face with a fourth semiconductor die arranged above the third semiconductor die;
wherein axes of any two adjacent semiconductor dies of a plurality of semiconductor dies in the stack structure are aligned with each other, and the first region of one of the any two adjacent semiconductor dies is aligned with the second region of another one of the any two adjacent semiconductor dies, and
wherein face-to-face means that top surfaces of two adjacent semiconductor dies face towards each other, and back-to-back means that bottom surfaces of two adjacent semiconductor dies face towards each other.

9. The semiconductor device according to claim 8, further comprising:
a plurality of pairs of signal transmission link groups, wherein each pair of the plurality of pairs of signal transmission link groups corresponds to a respective one of the plurality of pairs of signal via groups in each of the plurality of semiconductor dies, each of a plurality of signal transmission link groups comprises a plurality of signal transmission links, the plurality of signal transmission links in each of the plurality of signal transmission link groups are independent of each other and each spirally extend along the third direction, each of the plurality of signal transmission links in each of the plurality of signal transmission link groups corresponds to a respective one of the plurality of signal vias in a respective one of the plurality of signal via groups in each of the plurality of semiconductor dies, and each of the plurality of signal transmission links comprises the respective one of the plurality of signal vias in each of the plurality of semiconductor dies.

10. The semiconductor device according to claim 9, further comprising:
a plurality of pairs of bonding pillar groups, wherein the plurality of pairs of bonding pillar groups are located only between any two adjacent semiconductor dies stacked face-to-face with each other, each pair of the plurality of pairs of bonding pillar groups corresponds to a respective one of the plurality of pairs of signal via groups in each of the any two adjacent semiconductor dies stacked face-to-face with each other, to implement signal transmission between the any two adjacent semiconductor dies stacked face-to-face with each other, each of a plurality of bonding pillar groups comprises a plurality of bonding pillars, each of the plurality of bonding pillars corresponds to a respective one of the plurality of signal vias in each of the any two adjacent semiconductor dies stacked face-to-face with each other; and wherein each pair of the plurality of pairs of signal transmission link groups corresponds to a respective one of the plurality of pairs of bonding pillar groups located between the any two adjacent semiconductor dies stacked face-to-face with each other, each of the plurality of signal transmission links in each of the plurality of signal transmission link groups corresponds to a respective one of the plurality of bonding pillars in the respective one of the plurality of pairs of bonding pillar groups, and each of the plurality of signal transmission links comprises the respective one of the plurality of bonding pillars arranged between the any two adjacent semiconductor dies stacked face-to-face with each other.

11. The semiconductor device according to claim 9, wherein for any two adjacent semiconductor dies stacked back-to-back with each other, each of the plurality of signal vias in one of the any two adjacent semiconductor dies stacked back-to-back with each other corresponds to and is electrically connected with a respective one of the plurality of signal vias in another one of the any two adjacent semiconductor dies stacked back-to-back with each other.

12. The semiconductor device according to claim 10, wherein each of the plurality of semiconductor dies comprises a plurality of top metal interconnection structures, wherein the plurality of top metal interconnection structures are located on the top surface of the substrate, each of the plurality of top metal interconnection structures corresponds to and is electrically connected to a respective one of the plurality of signal via groups, each of the plurality of top metal interconnection structures comprises a plurality of conductive paths, each of the plurality of conductive paths corresponding to and being electrically connected to a respective one of the plurality of signal vias in the respective one of the plurality of signal via groups, and each of the plurality of signal transmission links comprises a respective one of the plurality of signal vias and a respective one of the plurality of conductive paths in each of the plurality of semiconductor dies;
wherein each of the plurality of top metal interconnection structures comprises a first conductive layer, a second conductive layer, and a plurality of connection elements, wherein the first conductive layer is located on the top surface of the substrate and comprises a plurality of first conductive elements spaced apart from each other, the plurality of first conductive elements are arranged in the polygonal shape, and each of the plurality of first conductive elements corresponds to and is electrically connected to a respective one of the plurality of signal vias in the respective one of the plurality of signal via groups; wherein the second conductive layer is located on the first conductive layer and comprises a plurality of second conductive elements spaced apart from each other, each of the plurality of second conductive elements corresponds to a respective one of the plurality of first conductive elements, the plurality of second conductive elements are arranged in the polygonal shape, and a portion of each of the plurality of second conductive elements is overlapped with a portion of the respective one of the plurality of first conductive elements; and wherein each of the plurality of connection elements corresponds to a respective one of the plurality of first conductive elements and a respective one of the plurality of second conductive elements, and each of the plurality of connection elements is configured to electrically connect the respective one of the plurality of first conductive elements with the respective one of the plurality of second conductive elements, to form a respective one of the plurality of conductive paths; and
wherein each of the plurality of first conductive elements comprises a first end and a second end, the first end being arranged opposite to the second end along an extension direction of said each of the plurality of first conductive elements, and each of the plurality of second conductive elements comprises a third end and a fourth end, the third end being arranged opposite to the fourth end along an extension direction of said each of the plurality of second conductive elements; wherein the first end of each of the plurality of first conductive elements corresponds to and is electrically connected to the respective one of the plurality of signal vias; and wherein for each of the plurality of second conductive elements and the respective one of the plurality of first conductive elements, an end of a respective one of the plurality of connection elements is electrically connected to the third end of said each of the plurality of second conductive elements, and another end of the respective one of the plurality of connection elements is electrically connected to the second end of the respective one of the plurality of first conductive elements.

13. The semiconductor device according to claim 12, wherein for the any two adjacent semiconductor dies stacked face-to-face with each other, each pair of the plurality of pairs of bonding pillar groups corresponds to a respective one of the plurality of top metal interconnection structures of each of the any two adjacent semiconductor dies stacked face-to-face with each other, an end of each of the plurality of bonding pillars is electrically connected to the fourth end of a respective one of the plurality of second conductive elements in one of the any two adjacent semiconductor dies stacked face-to-face with each other, and another end of each of the plurality of bonding pillars is electrically connected to the fourth end of a respective one of the plurality of second conductive elements in another one of the any two adjacent semiconductor dies stacked face-to-face with each other.

14. The semiconductor device according to claim 12, wherein each of the plurality of semiconductor dies further comprises:
a plurality of internal circuits, wherein each of the plurality of internal circuits corresponds to a respective one of the plurality of top metal interconnection structures, and each of the plurality of internal circuits is electrically connected to a respective one of the plurality of conductive paths in the respective one of the plurality of top metal interconnection structures; and
a plurality of lead-out wires, wherein each of the plurality of lead-out wires corresponds to a respective one of the plurality of internal circuits, an end of each of the plurality of lead-out wires is electrically connected to the respective one of the plurality of internal circuits, and another end of each of the plurality of lead-out wires is only electrically connected to a respective one of the plurality of first conductive elements in the respective one of the plurality of top metal interconnection structures.

15. The semiconductor device according to claim 14, wherein for each of the N cell structures, one of the plurality of signal transmission links is only electrically connected to one of the plurality of lead-out wires in one of the plurality of semiconductor dies.

16. The semiconductor device according to claim 15, further comprising:
an interface circuit, wherein the interface circuit is located in the base plate and is electrically connected to the plurality of pairs of signal transmission link groups, the interface circuit is configured to transmit a plurality of control signals to the plurality of signal transmission link groups, each of the plurality of control signals corresponding to a respective one of the plurality of signal transmission links in the plurality of signal transmission link groups, and each of the plurality of control signals being only led out from one of the plurality of lead-out wires in one of the plurality of semiconductor dies in each of the N cell structures,
wherein for each pair of the plurality of pairs of signal via groups in one of the plurality of semiconductor dies, the interface circuit outputs a first control signal to a lead-out wire electrically connected to one of the plurality of signal vias in one of the plurality of signal via groups through a respective one of the plurality of signal transmission links, and transmits a second control signal, which is different from the first control signal, to a lead-out wire electrically connected to one of the plurality of signal vias in another one of the plurality of signal via groups through another respective one of the plurality of signal transmission links.

17. A method for forming a semiconductor device, comprising:
providing a base plate;
forming a plurality of semiconductor dies, wherein each of the plurality of semiconductor dies comprises a substrate, and a plurality of pairs of signal via groups which are independent of each other, wherein the substrate comprises a top surface and a bottom surface arranged opposite to the top surface, a plurality of signal via groups are arranged in the substrate and spaced apart from each other, two signal via groups in each pair of the plurality of pairs of signal via groups are distributed symmetrically with respect to an axis located on the top surface of the substrate, one of the two signal via groups is distributed in a first region arranged on one side of the axis, and another one of the two signal via groups is distributed in a second region arranged on another side of the axis, the axis being parallel to a first direction or a second direction, each of the plurality of signal via groups comprises a plurality of signal vias arranged in a polygonal shape, any two of the plurality of signal vias in each of the plurality of signal via groups are electrically isolated from each other, each of the plurality of signal vias penetrates through the substrate along a third direction, wherein the first direction and the second direction are perpendicular to each other and are parallel to the top surface of the substrate, and the third direction is a direction perpendicular to the top surface of the substrate; and
forming a stack structure on the base plate based on the plurality of semiconductor dies, wherein the stack structure comprises N cell structures, the N cell structures are sequentially stacked on one another in the third direction and are electrically connected to each other, each of the N cell structures comprises four semiconductor dies, the four semiconductor dies in each of the N cell structures are sequentially stacked on one another along the third direction, a first semiconductor die at a bottommost layer of the four semiconductor dies is stacked face-to-face with a second semiconductor die arranged above the first semiconductor die, the second semiconductor die is stacked back-to-back with a third semiconductor die arranged above the second semiconductor die, and the third semiconductor die is stacked face-to-face with a fourth semiconductor die arranged above the third semiconductor die, wherein N is a positive integer,
wherein axes of any two adjacent semiconductor dies of the plurality of semiconductor dies in the stack structure are aligned with each other, and the first region of one of the any two adjacent semiconductor dies is aligned with the second region of another one of the any two adjacent semiconductor dies, and
wherein face-to-face means that top surfaces of two adjacent semiconductor dies face towards each other, and back-to-back means that bottom surfaces of two adjacent semiconductor dies face towards each other.

18. The method for forming the semiconductor device according to claim 17, wherein forming the plurality of semiconductor dies comprises:
forming the substrate, and defining, in the substrate, the first region arranged on said one side of the axis and the second region arranged on the other side of the axis;
forming, in each of the first region and the second region, the plurality of signal via groups penetrating through the substrate along the third direction; and
forming a plurality of top metal interconnection structures on the top surface of the substrate, wherein each of the plurality of top metal interconnection structures corresponds to and is electrically connected to a respective one of the plurality of signal via groups, each of the plurality of top metal interconnection structures comprises a plurality of conductive paths, each of the plurality of conductive paths corresponds to and is electrically connected to a respective one of the plurality of signal vias in the respective one of the plurality of signal via groups.

19. The method for forming the semiconductor device according to claim 18, wherein forming the plurality of top metal interconnection structures on the top surface of the substrate comprises:
forming a first conductive layer on the top surface of the substrate, wherein the first conductive layer comprises a plurality of first conductive elements spaced apart from each other, the plurality of first conductive elements are arranged in the polygonal shape, each of the plurality of first conductive elements comprises a first end and a second end, the first end is arranged opposite to the second end along an extension direction of said each of the plurality of first conductive elements, and the first end of each of the plurality of first conductive elements corresponds to and is electrically connected to a respective one of the plurality of signal vias in a respective one of the plurality of signal via groups;
forming a second conductive layer above the first conductive layer, wherein the second conductive layer comprises a plurality of second conductive elements spaced apart from each other, each of the plurality of second conductive elements corresponds to a respective one of the plurality of first conductive elements, the plurality of second conductive elements are arranged in the polygonal shape, each of the plurality of second conductive elements comprises a third end and a fourth end, the third end being arranged opposite to the fourth end along an extension direction of said each of the plurality of second conductive elements, and a portion of each of the plurality of second conductive elements is overlapped with a portion of the respective one of the plurality of first conductive elements; and
forming a plurality of connection elements between the first conductive layer and the second conductive layer, wherein for each of the plurality of second conductive elements and the respective one of the plurality of first conductive elements, an end of a respective one of the plurality of connection elements is electrically connected to the third end of said each of the plurality of second conductive elements, and another end of the respective one of the plurality of connection elements is electrically connected to the second end of the respective one of the plurality of first conductive elements, to form a respective one of the plurality of conductive paths.

20. The method for forming the semiconductor device according to claim 19, wherein forming the stack structure on the base plate based on the plurality of semiconductor dies comprises:
providing the four semiconductor dies;
placing the first semiconductor die on the base plate;
stacking the second semiconductor die above the first semiconductor die in a manner that the second semiconductor die is arranged face-to-face with the first semiconductor die;
stacking the third semiconductor die above the second semiconductor die in a manner that the third semiconductor die is arranged back-to-back with the second semiconductor die;
stacking the fourth semiconductor die above the third semiconductor die in a manner that the fourth semiconductor die is arranged face-to-face with the third semiconductor die, to form a cell structure comprising the first semiconductor die, the second semiconductor die, the third semiconductor die and the fourth semiconductor die; and
repeating above operations on the formed cell structure, to sequentially form the N cell structures stacked on one another along the third direction,
wherein the axes of the any two adjacent semiconductor dies in the stack structure are aligned with each other, and the first region of said one of the any two adjacent semiconductor dies is aligned with the second region of the other one of the any two adjacent semiconductor dies.

21. The method for forming the semiconductor device according to claim 20, wherein stacking the second semiconductor die above the first semiconductor die in the manner that the second semiconductor die is arranged face-to-face with the first semiconductor die comprises:
forming one of a plurality of bonding pillar groups on each of the plurality of top metal interconnection structures of the first semiconductor die, wherein each of the plurality of bonding pillar groups comprises a plurality of bonding pillars, a bottom end of each of the plurality of bonding pillars is bonded and connected to the fourth end of a respective one of the plurality of second conductive elements in the first semiconductor die,
wherein a top end of each of the plurality of bonding pillars is bonded and connected to a respective one of the plurality of top metal interconnection structures of the second semiconductor die, and the top end of each of the plurality of bonding pillars is bonded and connected to the fourth end of a respective one of the plurality of second conductive elements in the second semiconductor die.

22. The method for forming the semiconductor device according to claim 20, wherein stacking the third semiconductor die above the second semiconductor die in the manner that the third semiconductor die is arranged back-to-back with the second semiconductor die comprises:
contacting or electrically connecting each of the plurality of signal vias arranged in the second semiconductor die with a respective one of the plurality of signal vias arranged in the third semiconductor die.

23. The method for forming the semiconductor device according to claim 22, wherein each of the plurality of semiconductor dies further comprises a plurality of internal circuits, each of the plurality of internal circuits corresponding to a respective one of the plurality of top metal interconnection structures, wherein the method for forming the semiconductor device further comprises:
forming a lead-out wire between each of the plurality of internal circuits and the respective one of the plurality of top metal interconnection structures, to allow each of the plurality of internal circuits to be electrically connected to a respective one of the plurality of conductive paths in the respective one of the plurality of top metal interconnection structures.

24. The method for forming the semiconductor device according to claim 23, further comprising:
forming an interface circuit in the base plate;
electrically connecting the any two adjacent semiconductor dies in the stack structure with each other, to form a plurality of pairs of signal transmission link groups, each pair of the plurality of pairs of signal transmission link groups corresponding to a respective one of the plurality of pairs of signal via groups in each of the any two adjacent semiconductor dies, wherein each of a plurality of signal transmission link groups comprises a plurality of signal transmission links, each of the plurality of signal transmission links comprises a respective one of the plurality of signal vias in each of the any two adjacent semiconductor dies, a respective one of the plurality of conductive paths in each of the any two adjacent semiconductor dies, and a respective one of the plurality of bonding pillars arranged between the any two adjacent semiconductor dies stacked face-to-face with each other; and
electrically connecting the interface circuit to the plurality of pairs of signal via groups in a semiconductor die at a bottommost layer of the stack structure, and electrically connecting the interface circuit to the plurality of pairs of signal transmission link groups, to transmit a plurality of control signals to the plurality of signal transmission link groups, each of the plurality of control signals corresponding to a respective one of the plurality of signal transmission links in the plurality of signal transmission link groups, and each of the plurality of control signals being only led out to a respective one of the plurality of internal circuits through one lead-out wire in one of the plurality of semiconductor dies in each of the N cell structures; and wherein for each pair of the plurality of pairs of signal via groups in one of the plurality of semiconductor dies, the interface circuit is further configured to output a first control signal to a lead-out wire electrically connected to one of the plurality of signal vias in one of the plurality of signal via groups through a respective one of the plurality of signal transmission links, and to transmit a second control signal, which is different from the first control signal, to a lead-out wire electrically connected to one of the plurality of signal vias in another one of the plurality of signal via groups through another respective one of the plurality of signal transmission links.
